# EUROPÄISCHE PATENTSCHRIFT

(11) **EP 2 342 772 B1**
(45) Veröffentlichungstag und Bekanntmachung des Hinweises auf die Patenterteilung: **02.12.2015**
(21) Anmeldenummer: 09741205.0
(22) Anmeldetag: 25.09.2009
(51) Int. Cl.: H01L 51/54

(54) **ORGANISCHES ELEKTRONISCHES BAUELEMENT UND VERFAHREN ZU DESSEN HERSTELLUNG**
ORGANIC ELECTRONIC COMPONENT AND METHOD FOR THE PRODUCTION THEREOF
COMPOSANT ÉLECTRONIQUE ORGANIQUE ET SON PROCÉDÉ DE FABRICATION

(30) Priorität: 26.09.2008 DE 102008049286; 07.11.2008 DE 102008056391
(43) Veröffentlichungstag der Anmeldung: 13.07.2011
(73) Patentinhaber: OSRAM OLED GmbH, 93049 Regensburg (DE)
(72) Erfinder: SCHMID, Guenter, 91334 Hemhofen (DE); KRAUSE, Ralf, 91058 Erlangen (DE); KANITZ, Andreas, 91315 Höchstadt (DE); ADLER, Juergen, 91096 Kleinseebach (DE); SEIDEL, Stefan, 93152 Nittendorf (DE); HUNZE, Arvid, 91056 Erlangen (DE)
(74) Vertreter: Epping - Hermann - Fischer
(86) Internationale Anmeldenummer: PCT/DE2009/001359
(87) Internationale Veröffentlichungsnummer: WO 2010/034304

(56) Entgegenhaltungen:
- EP-A2- 1 011 155
- EP-A2- 1 672 714
- WO-A2-2004/015746
- US-A1- 2006 011 908
- US-B2- 7 141 313

## Beschreibung

Es wird ein organisches elektronisches Bauelement nach dem Anspruch 1 angegeben.

Ein weit verbreitetes Problem in organischen elektronischen Bauelementen ist es eine Schicht bereitzustellen, welche eine sehr hohe Elektronenleitfähigkeit besitzt. Die Elektronenleitfähigkeit in dem Bauelement ist oft die ausschlaggebende Größe für die Effizienz und Lebensdauer des Bauelements. Bei einer organischen LED (OLED) werden durch die Rekombination von Elektronen und Löchern Excitonen gebildet, welche Substanzen zur Emission von Strahlung anregen können. Bei solchen Bauelementen hängt auch die Lumineszenz direkt von der Excitonendichte ab und diese wiederum von der Rekombination von Elektronen und Löchern. In manchen Bauelementen werden zum Elektronentransport rein kristalline Schichten verwendet. Diese rein kristallinen Schichten haben den Nachteil, dass sie Bereiche unterschiedlicher Leitfähigkeit aufweisen. Dies hat zur Folge, dass die Ladungsträger immer den Weg des kleinsten Widerstandes wählen. Somit kommt es zum ungleichmäßigen Elektronenfluss in dieser Schicht. An den Stellen, wo ein deutlich erhöhter Elektronenfluss auftritt, kann es zu Überhitzung in der Schicht kommen und somit zur Schädigung.

Im Fall von elektrolumineszierenden Bauelementen führt dieser ungleicher Elektronenfluss des Weiteren zu einer inhomogenen Abstrahlung. In den Bereichen wo ein höherer Elektronenfluss auftritt und mehrere Excitonen gebildet werden, emittiert das Bauelement mehr Strahlung und ist somit heller als in den Bereichen wo ein niedriger Elektronenfluss vorliegt.

In der US 2006/0011908 A1 wird ein Licht-emittierendes Element mit niedriger Betriebsspannung beschrieben, das eine Elektronentransportschicht aufweist, die durch Co-Verdampfen eines Matrixmaterials wie Alq₃ mit Additiven erhalten wird. In der EP 1 011 155 A2 wird eine Mischschicht durch gemeinsames Abscheiden einer Elektronen-transportierenden organischen Verbindung mit einem Organometallkomplex erhalten. In der WO 2004/015746 wird beschrieben, dass eine Schicht aus [Ru(2,2',6',2"-terpyridin)₂]⁰ zwischen Lichtemittierender Schicht und Elektrode erzeugt wird.

Eine Aufgabe von Ausführungsformen der Erfindung besteht darin, eine elektronenleitende Schicht in einem organischen elektronischen Bauelement bereitzustellen, welche eine hohe Elektronenleitfähigkeit aufweist.

Die Aufgabe wird durch ein organisches elektronisches Bauelement nach Anspruch 1 gelöst. Weitere Ausführungsformen sowie Verfahren zur Herstellung des organischen elektronischen Bauelements sind Gegenstand weiterer Patentansprüche. Gegenstand der Erfindung ist ein organischesn elektronisches Bauelement umfassend ein Substrat, eine erste Elektrode, eine zweite Elektrode, und eine elektronenleitende Schicht die so angeordnet ist, dass sie mit mindestens einer der Elektroden elektrisch leitend verbunden ist, wobei die elektronenleitende Schicht einen Metallkomplex umfasst, welcher ein Metallzentralatom und eine organische Verbindung umfasst, wobei die organische Verbindung ausgewählt ist aus:

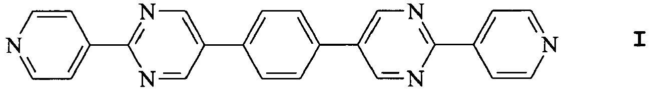

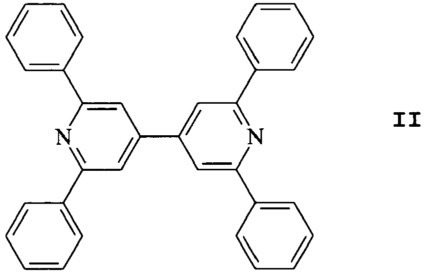

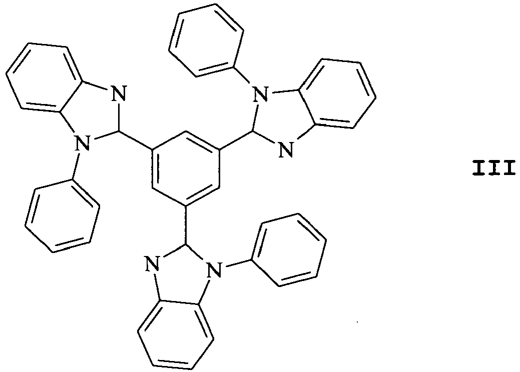

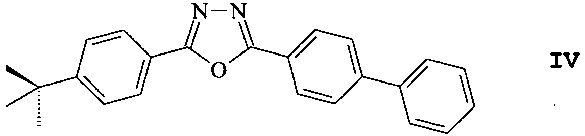

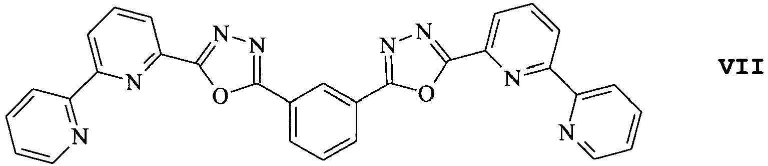

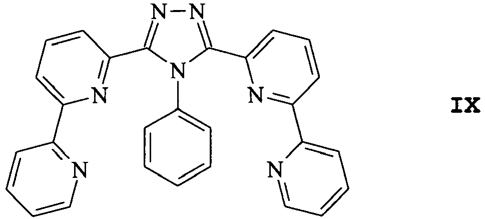

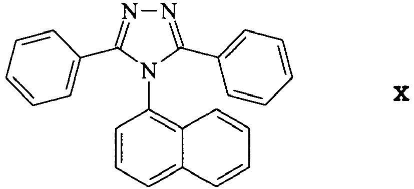

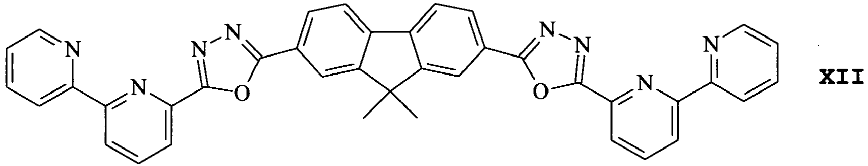

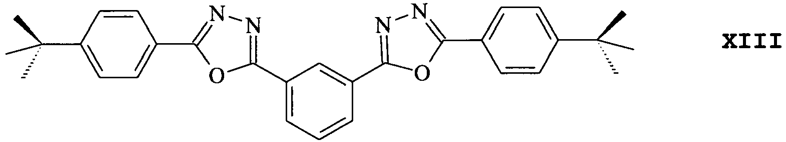

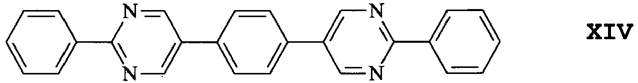

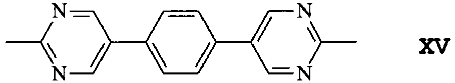

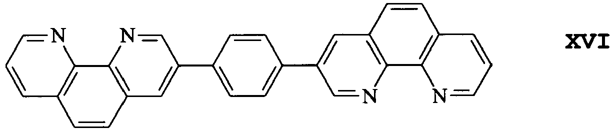

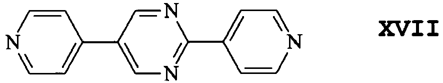

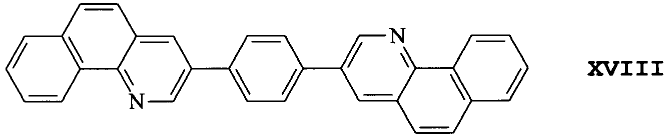

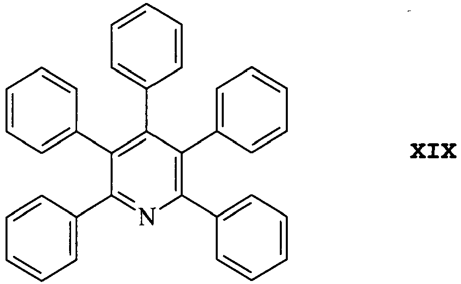

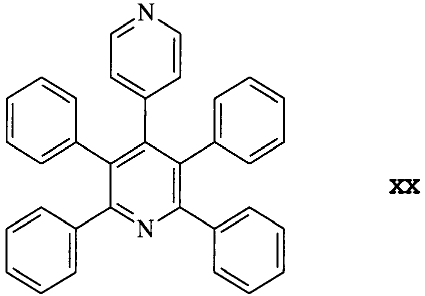

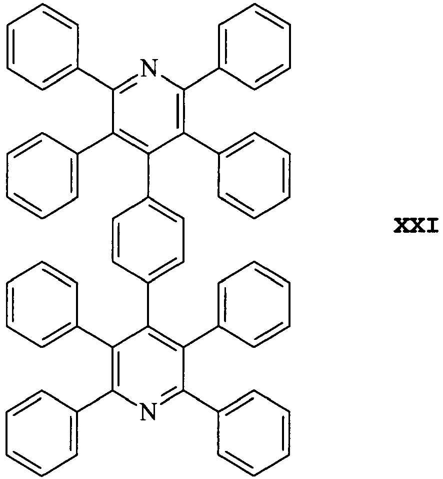

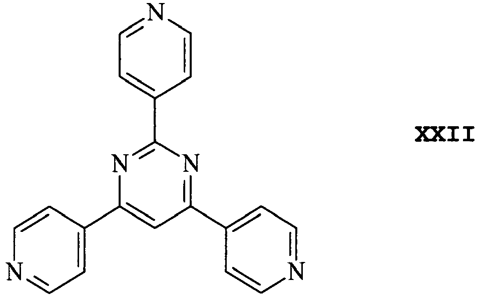

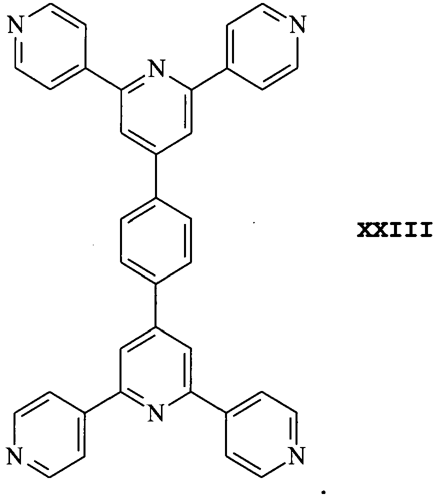

Die elektronenleitende Schicht kann durch gemeinsames Verdampfen eines Metallkomplexes mit einer organischen Verbindung erhalten werden wobei durch das gemeinsame Verdampfen die organische Verbindung an den Metallkomplex koordiniert.

Durch das gemeinsame Verdampfen des Metallkomplexes mit einer organischen Verbindung wechselwirken diese beiden Verbindungen in der Gasphase oder beim zusammentreffen auf der Substratoberfläche untereinander. Diese Wechselwirkung führt zu einer Koordination der Verbindungen untereinander. Die Verbindungen werden im koordinierten Zustand abgeschieden, so dass eine Schicht ausgebildet wird, in der eine Nahordnung vorliegt. Unter Nahordnung ist zu verstehen, dass nicht die gesamte Schicht an sich kristallin ist, aber um den Metallkomplex in seinem direkten Umfeld die organischen Verbindungen nach einem bestimmten Muster angeordnet sind, welches von dem gewählten Metallkomplex und der organischen Verbindung abhängt. Die gesamte Schicht an sich ist jedoch amorph und weist somit keine Fernordnung auf.

Über die Koordination der organischen Verbindung an den Metallkomplexe, und der damit verbundenen Überlappung der Orbitale, können über einen Metallkomplex-Liganden-Elektronentransfer zusätzliche Elektronen vom Metall auf den Liganden übertragen werden (Metall-Ligand-Charge-Transfer-Komplex). Diese Elektronen können für den Elektronentransport im organischen elektronischen Bauelement zur Verfügung stehen. Durch die Erhöhung der "freien" Elektronen wird die Elektronenleitfähigkeit im Bauelement deutlich verbessert. Dies führt zu einer Erhöhung der Effizienz und der Lebensdauer des organischen elektronischen Bauelements.

Die Koordination der organischen Verbindung an das Zentralatom kann direkt über ein weiteres Atom erfolgen oder aber auch über ein aromatisches System. Bei oder nach der Koordination der organischen Verbindung wird vorzugsweise keiner der zuvor vorhandenen Liganden des Metallkomplexes abgespalten, es findet also kein Ligandenaustausch statt. Der Metallkomplex ist also in der Lage weitere zusätzliche Liganden aufzunehmen und weist damit am Zentralatom freie Koordinationsstellen auf, die durch weitere Liganden belegt werden können.

In diesem Zusammenhang sei auf eine Schrift von F.A. Cotton verwiesen (F.A. Cotton et al., Organometallics, 1999, 18, 2724-2726). In der Publikation von Cotton wird aufgezeigt wie ein Aromat, in diesem Fall einen sechsfach methylierten Benzolring, an einen Rhodiumkomplex koordiniert. Es wird beschrieben, dass es durch die Koordination des aromatischen Systems zu einer Kettenbildung kommen kann, wobei zwei Metallkomplexe durch eine organische Verbindung verbrückt werden. Der Aromat steht hierbei senkrecht oder fast senkrecht zwischen benachbarten, verbrückten Metallkomplexen.

In einer weiteren Ausführungsform des organischen elektronischen Bauelements umfasst der Metallkomplex mehr als ein Zentralatom.

Das Vorhandensein von mehr als einem Zentralatom verbessert die Möglichkeit, dass mehrere organische Verbindungen gleichzeitig an den Metallkomplex koordinieren. Vorzugsweise weist der Metallkomplex zwei Metallzentralatome auf. In diesem Fall weißt jedes der beiden Zentralatome eine Koordinationsstelle auf, ohne dass es zur sterischen Behinderung kommt. Die beiden Zentralatome des Metallkomplexes können hierbei untereinander wechselwirken oder auch nicht. Metallkomplexe mit zwei Zentralatomen eignen sich besonders gut zur Ausbildung von Ketten. In diesem Zusammenhang ist nochmals auf die Publikation von Cotton in Organometallics verwiesen. Hier wird die Kettenbildung eines Metallkomplexes mit zwei Rhodiumzentralatomen betrachtet. Es ist eine kettenartige Abfolge von Metallkomplexen und von zwei benachbarte Komplexe verbrückenden Aromaten dargestellt. Hierbei steht der Aromat senkrecht zwischen den Metallkomplexen, und die Rh-Rh-Achse senkrecht auf dem Aromaten. Für eine erfindungsgemäße Ausführungsform sind die Metallkomplexe mit zwei Zentralatomen, die in der Verlängerung der Zentralatomachse noch keine Liganden aufweisen, bevorzugt, so dass das Zentralatom noch zwei freie bevorzugt gegenüberliegende Koordinationsstellen aufweist. Dies ist beispielsweise für den Rhodiumkomplex in der Publikation von Cotton gegeben. Für solche Metallkomplexe ist es aus sterischen Gründen besonders einfach, in Verlängerung der Zentralatomachse an beiden gegenüberliegenden Seiten zusätzliche Liganden anzulagern.

Eine Ausführungsform des organischen elektronischen Bauelements ist das Zentralatom oder sind die Zentralatome ausgewählt aus: Cr, Mo oder W.

Hierbei ist W ein bevorzugtes Metallzentralatom. Besonders bevorzugt ist es, wenn alle Zentralatome im Metallkomplex W sind. Elemente Cr, Mo und W erweisen sich aus zwei Gründen als besonders vorteilhaft. Zum einen verfügen sie über die Möglichkeit mit zusätzlichen Liganden eine Koordination einzugehen, zum anderen haben ihre Metallkomplexe bei geeigneter Wahl der Liganden eine sehr niedrige Ionisationsenthalpie. Dies bedeutet, dass diese Metallkomplexe über eine hohe Bereitschaft und Möglichkeit verfügen, "freie" Elektronen bereitzustellen. Diese Elektronen können beispielsweise auf die zusätzlich gebundenen Liganden übertragen werden. Über diese Koordination und den damit verbundenen Metallkomplex-Ligand-Elektronentransfer (charge-transfer-complex) können der elektronenleitenden Schicht zusätzliche Elektronen zum Ladungstransport zur Verfügung gestellt werden. Über diesen Elektronen kann der Ladungstransport im organischen elektronischen Bauelement gesteigert werden was die Effizienz des Bauelements steigert. In diesem Zusammenhang sei auf eine Publikation von F.A. Cotton (F.A. Cotton et al., Science, Vol. 298, 2002, Seite 1971-1974) verwiesen. In dieser Publikation von Cotton wird ein W₂(TBD-A)₄-Komplex betrachtet wie er in der folgenden Abbildung schematisch dargestellt ist:

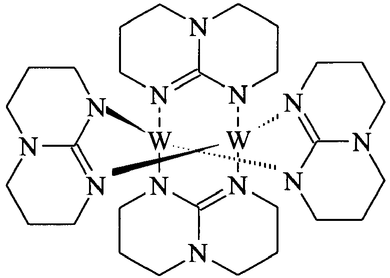

Cotton zeigt in seiner Publikation, dass dieser Komplex zu den Verbindungen gehört, deren Elektronenkonfiguration geschlossene also aufgefüllte Elektronenschalen aufweist und trotzdem über ein extrem niedriges Ionisationspotential verfügt. Cotton zeigt des Weiteren, dass die Zentralatome in diesem Komplex sehr hohe Oxidationsstufen einnehmen können. Somit können von den beiden W-Zentralatomen viele Elektronen abgegeben werden. In einer weiteren Publikation von Cotton (F.A. Cotton et al., Inorganic Chemistry Communications, Vol. 6, 2003, Seiten 121-126) wird von Cotton ein Syntheseweg für den W₂(TBD-A)₄-Komplex aufgezeigt.

Beschrieben wird auch ein organisches elektronisches Bauelement wobei die organische Verbindung einen Heteroaromaten umfasst.

Vorzugsweise umfasst die organische Verbindung mehr als einen Heteroaromaten. Dies ermöglicht es der organischen Verbindung an mehrere Metallkomplexe gleichzeitig zu koordinieren. Ein Heteroaromat hat gegenüber einem Aromaten den Vorteil, dass dieser nicht nur über das aromatische System (π-Elektronen) an ein Metallkomplex koordinieren kann, wie es in der Publikation von Cotton in Organometallics beschrieben wird, welche oben zitiert ist, sondern dass des Weiteren die Koordination auch direkt über das Heteroatom erfolgen kann.

Je größer also die Anzahl der Heteroaromaten in der organischen Verbindung ist, desto größer ist die Anzahl der möglichen Koordinationsstellen für einen Metallkomplex. Hierbei ist N ein bevorzugtes Heteroatom. N weist aufgrund des meist freien Elektronenpaares ein sehr gutes Koordinationsvermögen gegenüber Metallkomplexen auf.

Weiterhin dargelegt ist ein organisches elektronisches Bauelement wobei die organische Verbindung einen Heteroaromaten umfasst, welcher über eine C-C-Bindung mit einem Aromaten konjugiert ist.

Unter C-C-Bindung ist eine Kohlenstoff-Kohlenstoff-Einfachbindung zu verstehen, der Heteroaromat und der Aromat sind also nicht kondensiert. Ein derartiges System, bei dem der Heteroaromat mit weiteren Aromaten über C-C-Einfachbindungen verknüpft ist, hat gegenüber den kondensierten Systemen den Vorteil, dass es sterisch nicht so anspruchsvoll und voluminös ist, und somit leichter an einen Metallkomplex koordinieren kann, beziehungsweise besser an mehrere Metallkomplexe gleichzeitig koordinieren kann. Das Heteroatom im Heteroaromat ist vorzugsweise N, O oder S, wobei N besonders bevorzugt ist.

Darüber hinaus beschrieben ist ein organisches elektronisches Bauelement, wobei die organische Verbindung nur Heteroaromaten umfasst, welche keine kondensierten Systeme ausbilden. Die Heteroaromaten sind also nicht mit anderen heteroaromatischen oder aromatischen Systemen kondensiert. Auch hier ergibt sich wieder der sterische Vorteil der nicht-kondensierten Systeme gegenüber den kondensierten Systemen. Das Heteroatom im Heteroaromat ist vorzugsweise N, O oder S, wobei N besonders bevorzugt ist.

Beschrieben ist auch ein organisches elektronisches Bauelement wobei die organische Verbindung nur Heteroaromaten mit einem oder zwei Heteroatomen umfasst. Unter Heteroaromat ist ein gesamtes kondensiertes System zu verstehen. Das Heteroatom bzw. die Heteroatome im Heteroaromat sind vorzugsweise N, O oder S, wobei N besonders bevorzugt ist.

Genannt ist darüber hinaus ein organisches elektronisches Bauelement, wobei die organische Verbindung nur Heteroaromaten umfasst, deren Ringe aus sechs Atomen gebildet werden. Über diese Heteroaromaten kann in Konjugation mit anderen Heteroaromaten oder Aromaten am besten ein delokalisiertes π-Elektronensystem aufgebaut werden, welches gut in der Lage ist zusätzliche Ladung aufzunehmen. Das Heteroatom im Heteroaromat ist vorzugsweise N, O oder S, wobei N besonders bevorzugt ist.

Beschrieben wird zudem ein organisches elektronisches Bauelement, wobei die organische Verbindung die folgende allgemeine Formel aufweist: 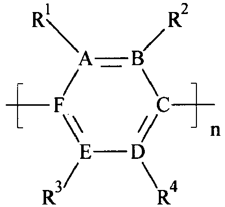 hierbei
- stehen die Ringglieder A bis F unabhängig voneinander für C oder eines oder zwei Ringglieder können N sein,
- n ist 2 bis 8, wobei die freien Valenzen der Enden jeweils unabhängig voneinander durch H, Methyl, Phenyl, 2-Pyridyl, 3-Pyridyl bzw. 4-Pyridyl abgesättigt sein können,
- R¹ bis R⁴ können jeweils unabhängig voneinander H, Methyl, Phenyl, 2-Pyridyl, 3-Pyridyl bzw. 4-Pyridyl sein und / oder R¹ und R² bzw. R³ und R⁴ können miteinander durch Butadien bzw. Azabutadieneinheiten verbunden sein, so dass ein Sechsring ausgebildet wird, sowie zwischen dem n-ten und (n+1)-ten Ring durch Ethylen- bzw. Azomethineinheiten verbunden sein, wobei Phenanthren- bzw. Azaphenanthreneinheiten gebildet werden.

Verbindungen mit dieser allgemeinen Formel können an Metallkomplexe koordinieren. Des Weiteren eignen sich Verbindungen dieser allgemeinen Formel zur Einstellung des Farbeindrucks des organischen elektronischen Bauelements im ausgeschalteten Zustand.

Durch eine geeignete Wahl des Metallkomplexes und der organischen Verbindung kann ein vorbestimmter Farbeindruck für das gewünschte äußere Erscheinungsbild zumindest im ausgeschalteten elektronischen Betriebszustand gewährleistet werden. Dies kann durch Ausbildung von Charge-Transfer-Komplexen in der elektronenleitenden Schicht möglich sein. Dabei bilden die Metallkomplexe und die organischen Verbindungen Elektronen-Donor-Akzeptor-Komplexe, deren Absorptionsbande vorzugsweise im sichtbaren Wellenlängenbereich liegen. Die Absorptionsbande der Charge-Transfer-Komplexe hängt dabei von der jeweiligen energetischen Lage ihrer HOMOs und LUMOs relativ zueinander ab. Die Charge-Transfer-Komplexe können somit einen vorbestimmten Farbeindruck ermöglichen.

Diese Verbindungen weisen zusätzlich gute Ladungstransporteigenschaften auf, welche sich über die Anzahl der Stickstoffatome im Ringsystem steuern lassen.

Die Absorptionsbande der durch Kokondensation gebildeten Komplexe beeinflusst gezielt den entstehenden Farbeindruck des Bauelements im ausgeschalteten Zustand.

Die Oligo-pyridyl-und/oder-pyrimidyl-arene sind in ihrer Anordnung frei permutierbar und können in ihrer Peripherie wiederum Phenyl, Pyridyl und Pyrimidyl sowie Wasserstoff und Methyl als Substituenten tragen. Unter Oligo soll ein Wertebereich von n = 2 bis 8 verstanden werden.

In einer weiteren Ausführungsform des organischen elektronischen Bauelements ist die organische Verbindung ausgewählt aus:

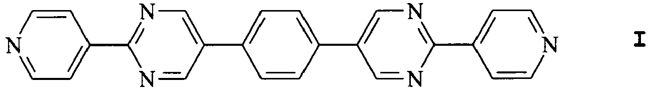

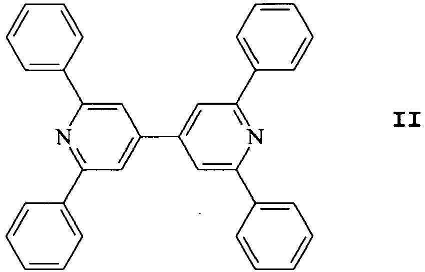

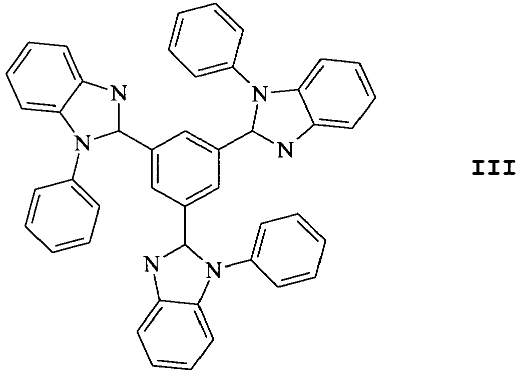

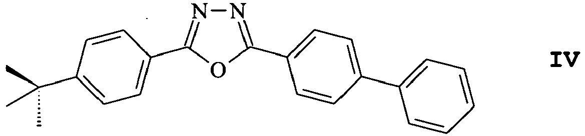

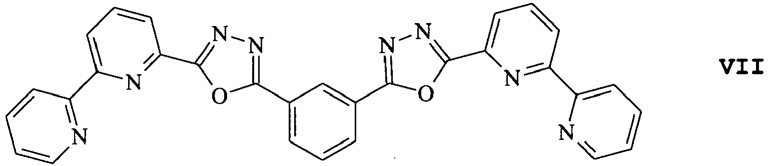

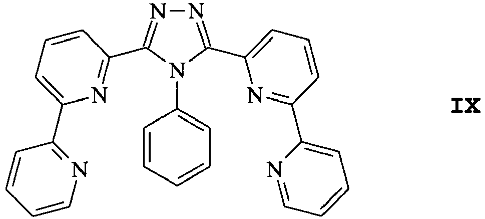

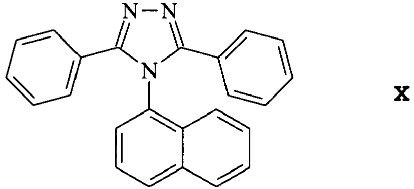

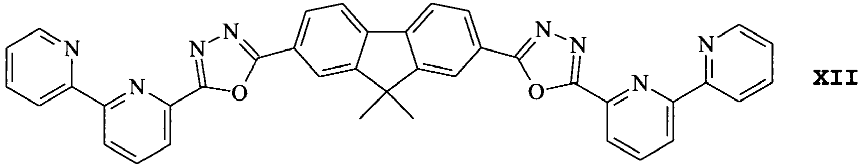

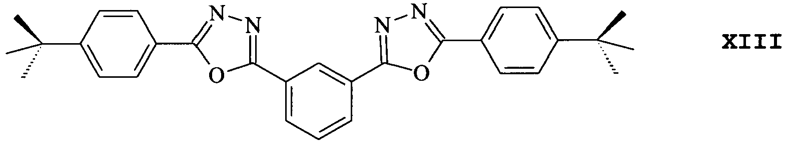

Beschrieben sind zudem die folgenden organischen Verbindungen:

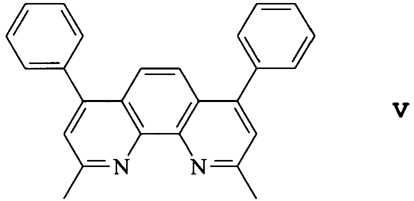

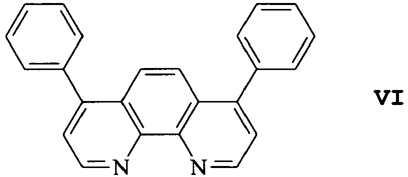

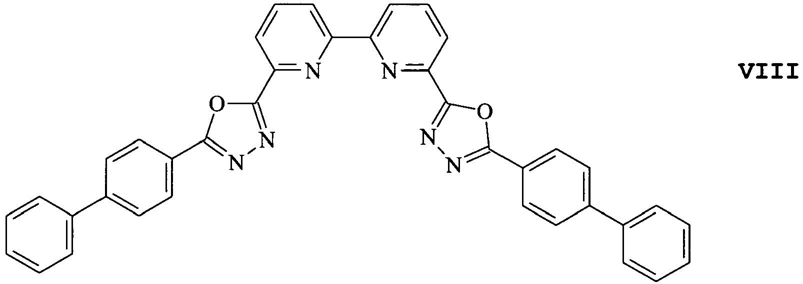

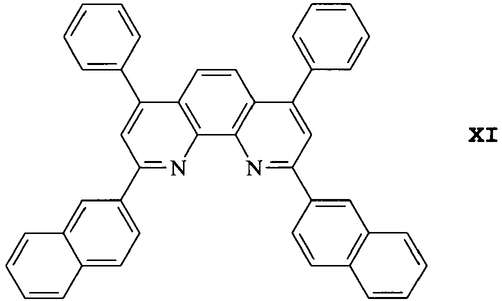

Die in den Strukturen I bis XIII dargestellten Verbindungen eignen sich besonders gut als organische Verbindung für die elektronenleitende Schicht. Jede dieser Verbindungen umfasst sowohl einen Aromaten wie auch einen Stickstoffheterozyklus. Jede dieser Verbindungen weist somit mehrere Koordinationsstellen für Metallkomplexe auf. Diese Verbindungen I bis XIII ermöglichen nicht nur die Ausbildung von zweidimensionalen Ketten, sondern durch ihre Vielzahl von Koordinationsstellen auch die Ausbildung von dreidimensionalen Netzwerken. Hierbei koordiniert eine organische Verbindung an mehr als zwei Metallkomplexe. Des Weiteren verfügen diese Verbindungen über große delokalisierte Elektronensysteme wie beispielsweise kondensierte Aromaten oder Aromaten die in elektronischer Konjugation zueinander stehen. Diese delokalisierten Elektronensysteme ermöglichen es den Verbindungen sehr gut weitere negative Ladungen aufzunehmen und zu transportieren, da diese zusätzliche Ladung einfach auf mehrere Atome im Molekül verteilt werden kann. Somit kann ein koordinierter Metallkomplex gut negative Ladung auf die an ihn koordinierte organische Verbindung übertragen. Des Weiteren können Elektronen von den organischen Verbindungen I bis XIII auch gut unter den organischen Verbindungen selbst weitergeleitet werden. Dies ist ebenfalls entscheidend für eine gute Elektronenleitfähigkeit in der elektronenleitenden Schicht.

In einer weiteren Ausführungsform des organischen elektronischen Bauelements ist die organische Verbindung ausgewählt aus:

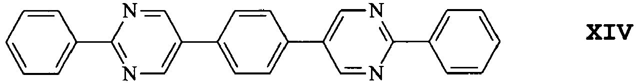

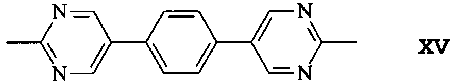

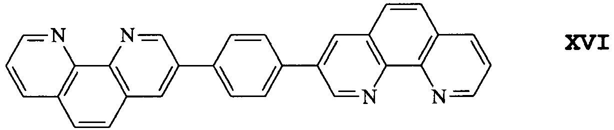

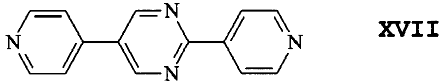

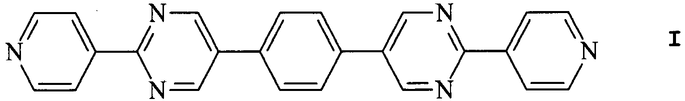

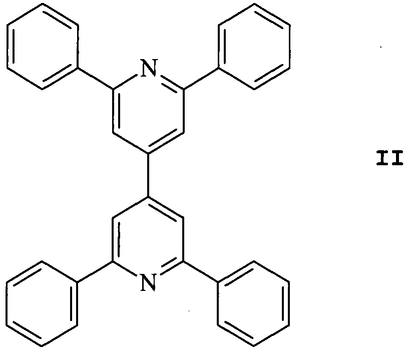

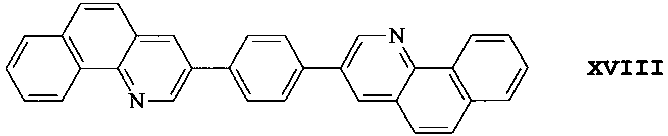

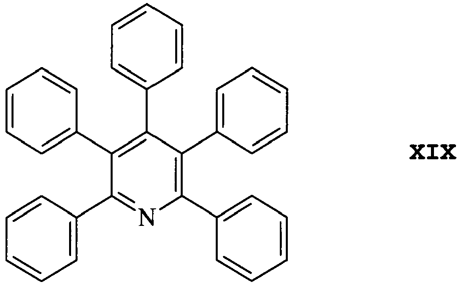

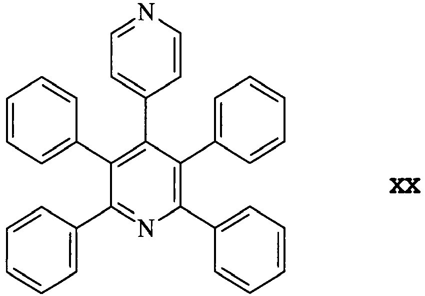

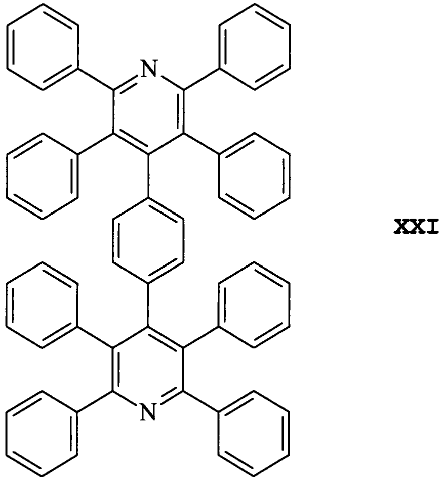

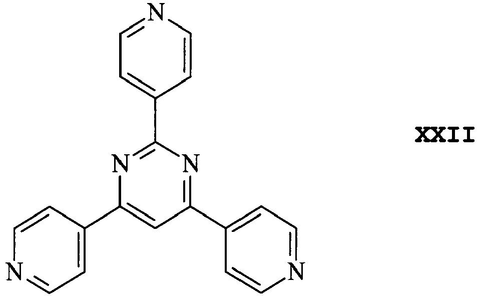

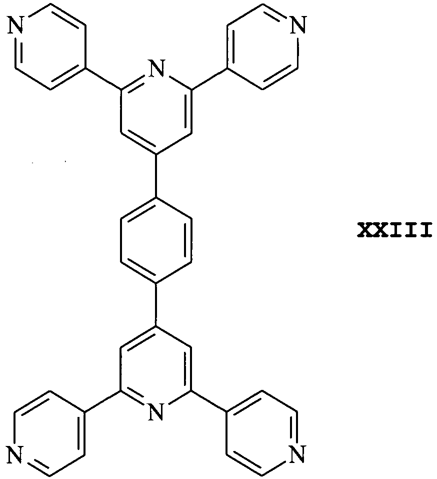

Die in den Strukturen I, II, XIV bis XXIII dargestellten Verbindungen eignen sich besonders gut als organische Verbindung für die elektronenleitende Schicht. Jede dieser Verbindungen umfasst einen Stickstoffheterozyklus, sowie zusätzlich einen weiteren Stickstoffheterozyklus oder einen Homoaromaten, welcher aus C-Atomen aufgebaut ist. Jede dieser Verbindungen weist somit mehrere Koordinationsstellen für Metallkomplexe auf. Diese Verbindungen I, II, XIV bis XXIII ermöglichen nicht nur die Ausbildung von zweidimensionalen Ketten, sondern durch ihre Vielzahl von Koordinationsstellen auch die Ausbildung von dreidimensionalen Netzwerken. Hierbei koordiniert die organische Verbindung an mehr als zwei Metallkomplexe. Des Weiteren verfügen diese Verbindungen über große delokalisierte Elektronensysteme wie beispielsweise kondensierte Aromaten oder Aromaten die in elektronischer Konjugation zueinander stehen. Diese delokalisierten Elektronensysteme ermöglichen es den Verbindungen sehr gut weitere negative Ladungen aufzunehmen und zu transportieren, da diese zusätzliche Ladung einfach auf mehrere Atome im Molekül verteilt werden kann. Somit kann ein koordinierter Metallkomplex gut negative Ladung auf die an ihn koordinierte organische Verbindung übertragen. Des Weiteren können Elektronen von den organischen Verbindungen I, II, XIV bis XXIII auch gut unter den organischen Verbindungen selbst weitergeleitet werden. Dies ist ebenfalls entscheidend für eine gute Elektronenleitfähigkeit in der elektronenleitenden Schicht.

In einer Ausführungsform des organischen elektronischen Bauelements verbrücken zumindest Teile der organischen Verbindungen zwei Metallkomplexe miteinander, so dass eine kettenartige Struktur ausgebildet wird und/oder verbrücken zumindest Teile der organischen Verbindungen mehr als zwei Metallkomplexe miteinander, so dass eine netzartige Struktur ausgebildet wird.

Durch geeignete Wahl der Metallkomplexe zum Beispiel zweikernige Metallkomplexe und geeignete Wahl der organischen Verbindungen wie beispielsweise die Verbindungen I bis XXIII kommt es durch das gemeinsame Verdampfen des Metallkomplexes mit der organischen Verbindung in der Gasphase bzw. auf der abgeschiedenen Oberfläche zu Wechselwirkungen, so dass die Verbindungen aneinander koordinieren. Die Koordination bleibt auch bei der Ausbildung der elektronenleitenden Schicht erhalten. Diese Koordination kann zur Ausbildung von zweidimensionalen Ketten oder dreidimensionalen Netzen führen. Diese Ketten oder Netze werden als solche im Verdampfungsprozess abgeschieden und liegen auch als solche in der elektronenleitenden Schicht im organischen elektronischen Bauelement vor. Die Ausbildung von ketten- oder netzartigen Strukturen ermöglicht es, das von den Metallkomplexen zusätzliche Elektronen auf die organischen Verbindungen übertragen werden können, welche dann für den Ladungstransport in der elektronenleitenden Schicht zur Verfügung stehen. In diesem Zusammenhang ist auf eine Publikation von F.A. Cotton (F.A. Cotton et al., Inorganic Chemistry, Vol. 41, No. 11, 2002, Seite 2903-2908) verwiesen. In dieser Publikation wird unter anderem an einem Metallkomplex mit zwei Rhodiumzentralatomen und einer siliziumorganischen Verbindung aufgezeigt wie es durch Mehrfachkoordination von mehreren Metallkomplexen an eine organische Verbindung zur Ausbildung von kettenartigen Strukturen kommen kann. In einem weiteren Beispiel in der Publikation von Cotton wird am Beispiel eines Tripyridinmethanols (HO-C-(C₅H₄N)₃) gezeigt, dass das Pyridin gleichzeitig über das Stickstoffheteroatom und über das aromatische System an zwei Metallkomplexe koordinieren kann. Die beiden weiteren Pyridinsubstituenten des Moleküls können ebenso an weitere Metallkomplexe koordinieren. Dieses Beispiel zeigt deutlich, dass es durch geeignete Wahl der organischen Verbindung möglich ist gleichzeitig an mehrere Metallkomplexe zu koordinieren. Durch die entsprechende Wahl der Metallkomplexe können auch mehr als eine organische Verbindung an diesen koordinieren, wodurch es zu kettenartigen und/oder netzartigen Strukturen in der elektronenleitenden Schicht kommt.

In einer Ausführungsform des organischen elektronischen Bauelements ist die elektronenleitende Schicht amorph und weist eine mikro- bis nanokristalline Nahstruktur auf.

Scheidet man organische Verbindungen, wie sie beispielsweise für elektronenleitende Schichten verwendet werden, über Verdampfung ab, so kann es zur Kristallisation der organischen Verbindungen kommen. Eine rein kristalline elektronenleitende Schicht hat sich als nachteilig erwiesen, da diese Schicht Bereiche unterschiedlicher Leitfähigkeit aufweist. Durch das Anlegen einer Spannung entstehen somit in der Schicht unterschiedliche Stromdichten. In Bereichen mit sehr hohen Stromdichten kann es zu Überhitzung und zu Beschädigung der elektronenleitenden Schicht kommen. Im Fall von lichtemittierenden Bauelementen führte die unterschiedliche Leitfähigkeit zusätzlich zu einer inhomogenen Abstrahlung. Das Problem wird durch eine makroskopisch bis nanoskopisch amorphe elektronenleitende Schicht gemindert. Eine solche Schicht ist erhältlich durch das gemeinsame Verdampfen der organischen Verbindung mit einem Metallkomplex, wobei die organische Verbindung an den Metallkomplex koordiniert und dadurch die Kristallisation unterbindet. Durch den Metallkomplex muss aber sichergestellt werden, dass die jetzt makroskopisch bis nanoskopisch amorphe Struktur immer noch gute elektronenleitende Eigenschaften besitzt. Dies kann beispielsweise dadurch geschehen, dass die zusätzliche Verbindung zusätzliche Ladungsträger bereitstellt. Eine organische Verbindung, welche an den Metallkomplex koordiniert und somit mikrokristalline Strukturen ausbildet, ist in der Lage zusätzliche Ladungsträger, welche vom Zentralatom bereitgestellt werden, aufzunehmen. Somit wird die gegenüber der kristallinen Schicht reduzierte Mobilität der Ladungsträger durch eine Erhöhung der Anzahl der Ladungsträger kompensiert. Ein organisches elektronisches Bauelement, beispielsweise eine OLED, welche eine solche Schicht umfasst, leuchtet homogen. An den Korngrenzen von OLED-Vorrichtungen, die makrokristalline Schichten aufweisen ändern sich die Leitfähigkeiten, so dass es zu einem inhomogenen Leuchtbild kommt bzw. beispielsweise eine LED durch Überstrom an gewissen Stellen zerstört wird.

In einer Ausführungsform des organischen elektronischen Bauelements umfasst die elektronenleitende Schicht keine strahlungsemittierenden Substanzen.

Somit kann bei dieser Ausführungsform aus der elektronenleitenden Schicht keine Strahlung emittiert werden. Weder die organische Verbindung noch der Metallkomplex sind bei dieser Ausführungsform in der Lage Strahlung zu emittieren.

Eine Ausführungsform des organischen elektronischen Bauelements umfasst einen Metallkomplex dessen HOMO (highest occupied molecular orbital) näher an seiner Ionisationsenergie liegt, als das LUMO (lowest unoccupied molecular orbital) organischen Verbindung, welche zusätzlich an den Metallkomplex koordiniert.

Dies ermöglicht es, dass auch die Metallkomplexe, die eine abgeschlossene Elektronenstruktur besitzen, Elektronen über Komplex-Liganden-Ladungstransfer vom Komplex auf den Liganden übertragen. Diese übertragenen Elektronen leisten einen wesentlichen Beitrag zur Elektronenleitfähigkeit der elektronenleitenden Schicht. In diesem Zusammenhang sei nochmals auf die Publikation von Cotton in Science, welche bereits in einem vorangehenden Abschnitt diskutiert wurde, verwiesen. In dieser Publikation beschreibt Cotton die extrem niedrige Ionisierungsenthalpie von Komplexen der allgemeinen Formel M₂(TBD-A)₄, wobei in der Publikation das Zentralatom M ausgewählt ist aus Cr, Mo oder W. TBD-A steht für das Anion von 1,5,7-Triazabicyclo[4.4.0]dec-5-ene. Cotton führt in seiner Publikation eine genauere Betrachtung der Orbitale des Metallkomplexes sowie des TBD-A-Liganden durch. Hierbei zeigt er, dass die niedrige Ionisationsenthalpie unter anderem in der Lage des HOMOs des Metallkomplexes relativ zum LUMO des TBD-A-Liganden begründet liegt.

Das organische elektronische Bauelement ist vorzugsweise als organische LED (OLED) ausgebildet, welche eine elektrolumineszierende Schicht umfasst. Bei dem organischen elektronischen Bauelement kann es sich aber beispielsweise auch um einen organischen Feldeffekttransistor um eine organische Solarzelle oder eine organischen Fotodetektor handeln. Ein organischer Feldeffekttransistor (OFET) besitzt drei Anschlüsse: Source, Gate und Drain. Das Substrat kann hierbei als Gate-Elektrode genutzt werden. Ist dies der Fall, so folgt auf das Substrat eine Isolatorschicht, auf der der Source und Drain Anschluss angeordnet sind. Sowohl zwischen Source und Drain wie auch über beiden Anschlüssen ist eine organische Halbleiterschicht angeordnet. Bei der organischen Solarzelle sind auf einem Substrat übereinander zwei Elektroden angeordnet, zwischen denen sich eine organische, photoaktive Schicht befindet. Die photoaktive Schicht absorbiert das Licht, wodurch es in der Schicht zur Ladungstrennung kommt. Die so gebildeten Elektronen wandern zur Anode und die Löcher zur Kathode wodurch ein Stromfluss generiert wird.

Die elektronenleitende Schicht eignet sich besonders gut für organische elektronische Bauelemente deren Effizienz unter anderem von einem guten Elektronentransport abhängt. So hängt beispielsweise bei einer OLED die Lumineszenz direkt von der Anzahl der gebildeten Excitonen ab. Diese hängt wiederum davon ab, wie viele Elektronen und Löcher rekombinieren. Ein guter Elektronen- und Lochtransport führen somit zu einer hohen Rekombinationsrate und somit zu einer guten Lumineszenz und Effizienz der OLED.

Neben dem organischen elektronischen Bauelement selbst werden auch Verfahren zur Herstellung des organischen elektronischen Bauelements beansprucht.

Eine Variante des Verfahrens zur Herstellung eines organischen elektronischen Bauelements umfasst die Verfahrensschritte Bereitstellen eines Substrates als Verfahrensschritt A), Aufbringen einer ersten Elektrode im Verfahrensschritt B), Abscheiden einer elektronenleitenden Schicht auf dem Substrat als Verfahrensschritt C), Aufbringen einer zweiten Elektrode im Verfahrensschritt D), wobei das Abscheiden der elektronenleitenden Schicht durch gleichzeitiges Verdampfen eines Metallkomplexes und einer organischen Verbindung erfolgt und
wobei beim gleichzeitigen Verdampfen die organische Verbindung in der Gasphase an den Metallkomplex koordiniert, wobei die organische Verbindung ausgewählt ist aus:

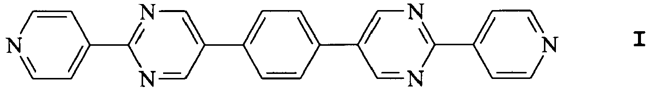

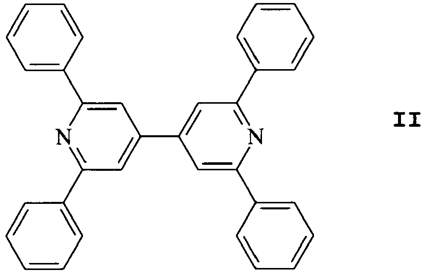

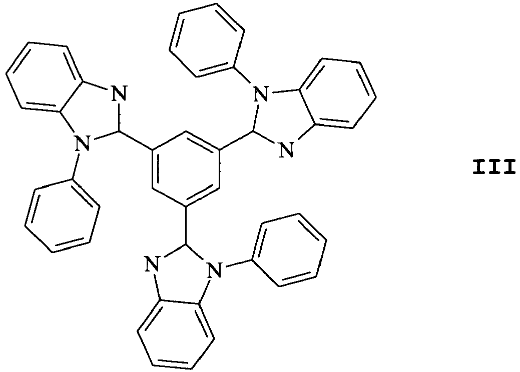

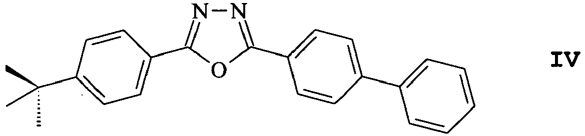

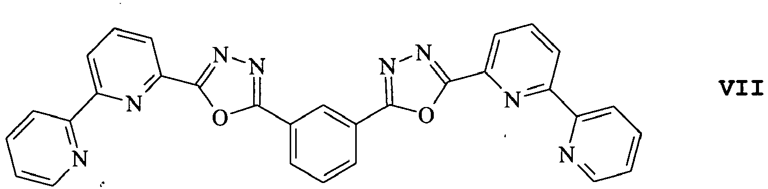

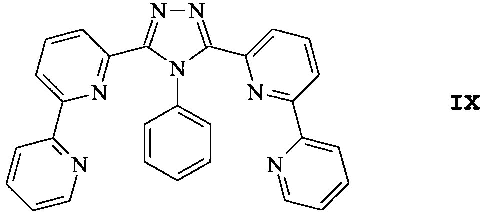

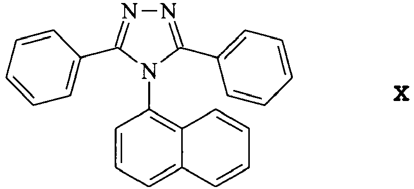

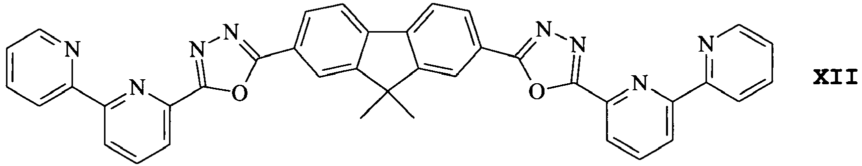

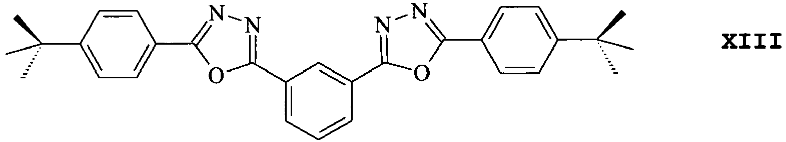

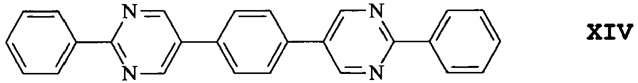

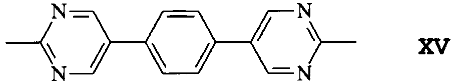

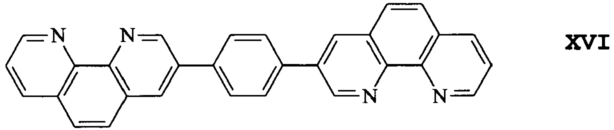

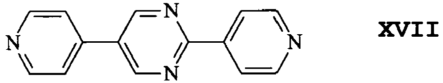

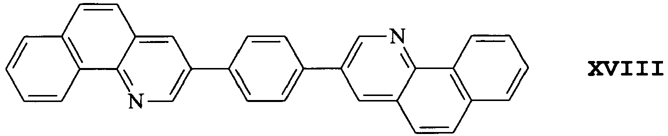

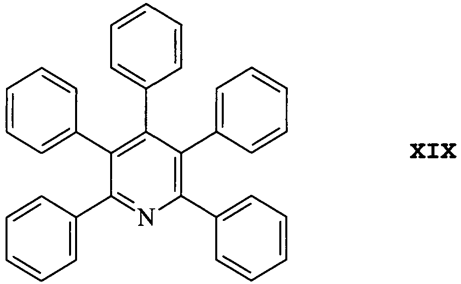

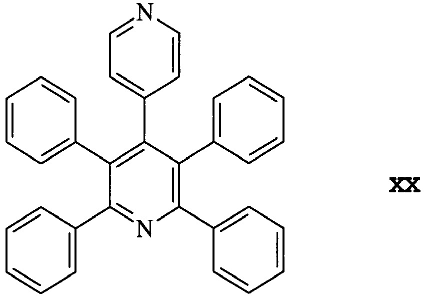

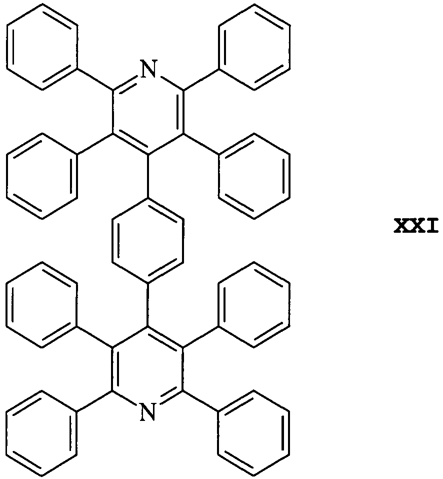

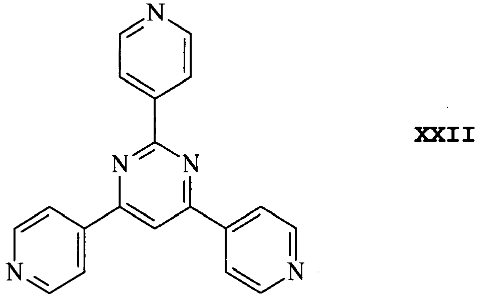

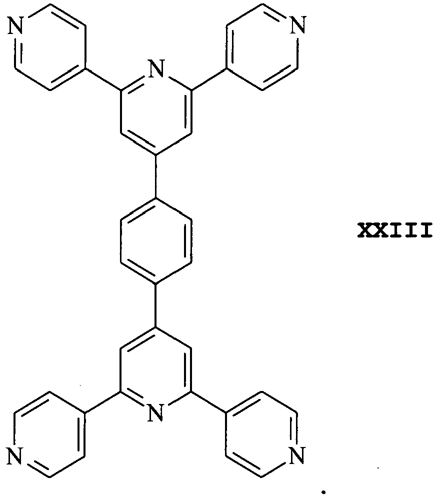

Durch ein solches Verfahren kann beispielsweise ein organisches elektronisches Bauelement gefertigt werden, wie es in Anspruch 1 beansprucht wird. Die elektronenleitende Schicht kann hierbei direkt auf ein Substrat abgeschieden werden oder es können zuvor auf dem Substrat andere Schichten abgeschieden werden, wie beispielsweise eine Elektrodenschicht, wobei dann die elektronenleitende Schicht auf die sich bereits auf dem Substrat befindlichen Schichten abgeschieden wird. Das Abscheiden der elektronenleitenden Schicht erfolgt durch gleichzeitiges Verdampfen eines Metallkomplexes und einer organischen Verbindung. Das gleichzeitige Verdampfen ermöglicht es den Molekülen untereinander wechselzuwirken.

In einer weiteren Verfahrensvariante koordiniert die organische Verbindung an den Metallkomplex durch das gemeinsame Verdampfen.

Durch das zeitgleiche Verdampfen von Metallkomplexen und organischer Verbindung liegen beide Verbindungen zeitgleich nebeneinander in der Gasphase vor. Dies ermöglicht es der organischen Verbindung an den Metallkomplex in der Gasphase zu koordinieren. Die Koordination kann beispielsweise über einen Heteroaromaten in der organischen Verbindung erfolgen. Die Koordination bleibt auch beim Abscheiden zur elektronenleitenden Schicht bestehen.

Es besteht aber auch die Möglichkeit, dass der Metallkomplexen und die organischer Verbindung erst auf der zu beschichtenden Oberfläche oder beim Auftreffen auf die Oberfläche aufeinandertreffen und unter Bildung der elektronenleitende Schicht die organische Verbindung an den Metallkomplex koordiniert.

In einer weiteren Verfahrensvariante wird die elektronenleitende Schicht als kettenartige oder netzartige Struktur abgeschieden.

Durch die Koordination der organischen Verbindung an den Metallkomplex in der Gasphase können sich kettenartige oder netzartige Strukturen ausbilden. Diese kettenartigen oder netzartigen Strukturen werden dann auch als solche abgeschieden und liegen auch als solche in der elektronenleitenden Schicht im organischen elektronischen Bauelement vor.

Beim Auftreffen auf die Oberfläche sind die Moleküle noch soweit beweglich, dass sich die Koordinationsstellen finden und der entsprechende Energiebeitrag frei wird, d.h. es zu einer Koordination kommen kann.

In einer Verfahrensvariante wird der Grad der Vernetzung der elektronenleitenden Schicht durch das Verhältnis zwischen Metallkomplex und der organischen Verbindung beim Verdampfen gesteuert.

Je nach Verhältnis von Metallkomplex zu organischer Verbindung kann der Grad der Vernetzung und somit die Ausbildung von netzartigen oder kettenartigen Strukturen gesteuert werden. Bezugsweise wird die organische Verbindung in einen Überschuss bezogen auf das Molverhältnis zum Metallkomplex verdampft.

Hierbei kann der Anteil des Metallkomplexes in der Schicht, welche den Metallkomplex und die organische Verbindung umfasst bei 1 bis 50 mol-% liegen, ein Anteil von 5 bis 25 mol-% ist bevorzugt, ein Anteil von 10 bis 15 mol-% besonders bevorzugt.

In einer weiteren Verfahrensvariante koordiniert die organische Verbindung vor dem Verdampfen nicht an den Metallkomplex.

Der Metallkomplex und die organische Verbindung können beispielsweise aus zwei unterschiedlichen, räumlich voneinander getrennten Vorlagen verdampft werden. Es ist jedoch auch möglich, die beiden Verbindungen in eine Vorlage zu geben, ohne das in der festen Phase eine Reaktion oder Koordination unter den Verbindungen stattfindet und das die Verbindungen dann aus der gemeinsamen Vorlage verdampft werden.

Im Folgenden sollen exemplarisch anhand eines Beispiels eine Variante eines Herstellungsverfahrens näher beschrieben werden.

In einem Vakuumrezipienten werden in einem elektrisch beheizbaren Quarz- oder Keramiktiegel 200 mg W₂(TBD-A)₄ vorgelegt. In einem weiteren Quarz- oder Keramiktiegel wird die organische Verbindung der oben erwähnten Struktur I vorgelegt. Es wird eine Glasplatte 60 mm x 60 mm mit einer strukturierten ITO-Elektrode (Indiumzinnoxid) auf einem Substrathalter circa 25 cm entfernt von den Tiegeln befestigt. Die Substratblende wird geschlossen und die beiden Quellen auf eine Abscheidungsrate von 4,5 nm/Sek. eingeregelt. Das Mol-Verhältnis von Metallkomplex zu organischer Verbindung beim Verdampfen betrug 1 zu 9. Es wird eine elektronenleitende Schicht mit einer Schichtdicke von 150 nm abgeschieden. Die elektronenleitende Schicht weist ein dreidimensionales Netzwerk aus dem Metallkomplex W₂(TBD-A)₄ und der organischen Verbindung I auf. Das organisch elektronische Bauelement wird mit einer 150 nm dicken Aluminiumelektrode vervollständigt.

In einer weiteren Variante des zuvor beschriebenen Herstellungsverfahrens für ein organisches elektronisches Bauelement, das eine OLED ist, wird vor der elektronenleitenden Schicht eine 10 nm dicke Schicht der organischen Verbindung der oben erwähnten Struktur I aufgedampft. Aufgrund der geringen Schichtdicke kommt es hier nicht zur Kristallisation der organischen Verbindung. Die zuvor aufgedampfte Schicht aus der organischen Verbindung I reduziert die Emissionslöschung durch den W₂(TBD-A)₄-Komplex. Das bedeutet, dass der Anteil der Strahlung, die im Bauelement wieder absorbiert wird, reduziert wird. In einer weiteren Verfahrensvariante wird anstelle der organischen Verbindung der oben erwähnten Struktur I die organische Verbindung der oben erwähnten Struktur II verwendet.

Im Folgenden sollen Varianten der Erfindung anhand von Figuren und Ausführungsbeispielen näher erläutert werden.

Es zeigen:
- Figur 1: eine schematische Seitenansicht einer Ausführungsform, welche als OLED ausgebildet ist und eine separate emittierende Schicht aufweist,
- Figur 2: eine schematische Seitenansicht einer Ausführungsform, welche als OLED ausgebildet ist, und neun Schichten umfasst,
- Figur 3: die Strukturformeln von drei chemischen Verbindungen, die in einer OLED Verwendung finden,
- Figur 4: die Energieniveaus in einer Ausführungsform eines optoelektronischen Bauelements,
- Figur 5: drei Messkurven von einer Ausführungsform einer OLED bei denen die Stromdichte gegen die Spannung aufgetragen ist,
- Figur 6: drei Messkurven von einer Ausführungsform einer OLED bei denen die Lumineszenz gegen die Spannung aufgetragen ist,
- Figur 7: drei Messkurven von einer Ausführungsform einer OLED bei denen die Strahlungseffizienz gegen die Lumineszenz aufgetragen ist,
- Figur 8: drei Messkurven von einer Ausführungsform einer OLED bei denen die Lumineszenz gegen die Zeit aufgetragen ist,
- Figur 9: eine schematische Seitenansicht einer Ausführungsform, welche als organischer Feldeffekttransistor ausgebildet ist.

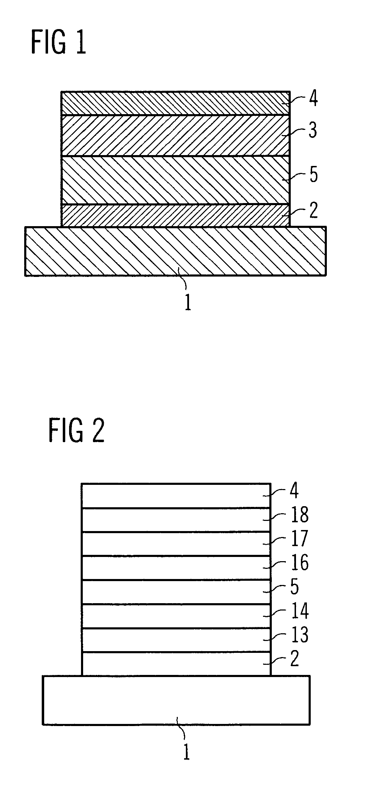

Figur 1 zeigt eine Schichtenfolge umfassend ein Substrat 1, darauf angeordnet eine erste Elektrode 2 und eine zweite Elektrode 4. Zwischen den beiden Elektroden liegen die elektronenleitende Schicht 3, sowie die emittierende Schicht 5. Durch das Anlegen von Spannung an die Elektroden wird von einer der beiden Elektroden, der Kathode, Elektronen in die Schichten 3 und 5 injiziert und von der anderen Elektrode Löcher. Durch die Rekombination der Elektronen und Löcher können sich Excitonen bilden. In der in Figur 1 dargestellten Ausführungsform wird die Strahlung aus der emittierenden Schicht 5 emittiert. In dieser befinden sich die Substanzen, welche durch Excitonen zur Emission angeregt werden können. Hierbei kann es sich beispielsweise um phosphoreszierende oder fluoreszierende Substanzen handeln.

Figur 2 zeigt eine Ausführungsform des Bauelements, welches als OLED ausgebildet ist. In der Abbildung ist eine schematische Seitenansicht eines Schichtstapels aus neun Schichten dargestellt. Dabei ist auf einem Substrat 1, das beispielsweise aus Glas ist, eine erste Elektrode 2, die beispielsweise transparent und aus ITO (Indium-Zinn-Oxid) ist angeordnet. Auf dieser Elektrode 2 ist eine Lochinjektionsschicht 13 angeordnet, auf der wiederum eine Lochtransportschicht 14 angeordnet ist. Auf der Lochtransportschicht 14 befindet sich eine organische aktive Schicht, die organische emittierende Schicht 5, auf der wiederum eine lochblockierende Schicht 16, auf die eine Elektronentransportschicht 17 folgt und auf dieser eine Elektroneninjektionsschicht 18 angeordnet sind. Auf der Elektroneninjektionsschicht 18 befindet sich eine zweite Elektrode 4, beispielsweise eine Metallelektrode.

Beim Anlegen einer Spannung zwischen erster und zweiter Elektrodenschicht 2, 4 fließt Strom durch das Bauelement und in der emittierenden Schicht 5 wird Strahlung abgegeben, die beispielweise in Form von sichtbarem Licht beispielsweise über die erste Elektrodenschicht 2 und das Substrat 1 aus dem Bauelement ausgekoppelt werden kann. Alternativ kann auch zusätzlich oder alleine die zweite Elektrodenschicht 4 transparent ausgeformt sein und das Licht das Bauelement über beide Elektrodenschichten oder nur über die zweite Elektrodenschicht 4 verlassen.

Die elektronenleitende Schicht gemäß der vorliegenden Erfindung kann hierbei jede Schicht sein, in der Elektronen transportiert werden. Vorzugsweise handelt es sich bei der elektronenleitenden Schicht gemäß der Erfindung um die Elektronentransportschicht 17 oder die Elektroneninjektionsschicht 18. Durch den verbesserten Elektronentransport können mehr Elektronen und Löcher rekombinieren, wodurch mehr Excitonen gebildet werden. Durch die gesteigerte Zahl an Excitonen wird die Emission und somit die Lichtausbeute erhöht.

Die elektronenleitende Schicht 3 gemäß der vorliegenden Erfindung kann hierbei auch eine Ladungsträgererzeugungsschicht (in der Abbildung nicht dargestellt) sein. Diese Ladungsträgererzeugungsschicht kann mit oder ohne eine Zwischenschicht an eine Lochtransportschicht grenzen. Eine Ladungsträgererzeugungsschicht ermöglicht es beispielsweise verschiedene OLEDs miteinander zu stapeln. Die Ladungsträgererzeugungsschicht kann zu diesem Zweck, als Zwischenschicht zwischen zwei OLED-Stapeln angeordnet, mit einer weiteren Spannungsversorgung versehen werden. Das kann insbesondere bedeuten, dass die Zwischenschicht so eingestellt werden kann, dass die zwei OLED-Stapel mit verschiedenen Spannungspotentialen angesteuert werden können.

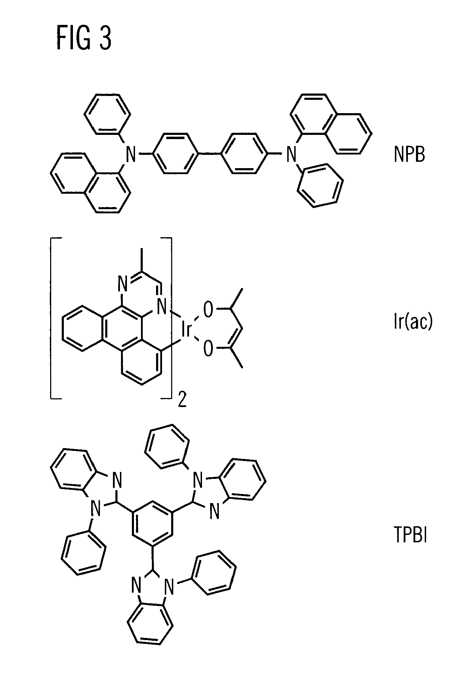

Figur 3 zeigt die Struktur von drei organischen Verbindungen wie sie beispielsweise in einer OLED zum Einsatz kommen können. Die erste Strukturformel zeigt NPB (N,N'-Di(naphthyl-1-yl)-N-N'-diphenyl-benzidin) welches beispielsweise als Lochtransportschicht und Matrix für emittierende Stoffe geeignet ist. Die zweite Strukturformel zeigt Ir(ac) (Iridium(III)bis(2-methyldibenzo-[f,h]quinoxalin)(acetylacetonat)). Der Ir-Komplex kann beispielsweise als roter phosphoreszierender Farbstoff in einer OLED verwendet werden. Die dritte Strukturformel zeigt TPBI (1,3,5-Tris(1-phenyl-1H-benzimidazol-2-yl)benzene), die organische Verbindung III. Diese Verbindung kann unter anderem für die löcherblockierende Schicht sowie für die elektronenleitende Schicht 3 verwendet werden.

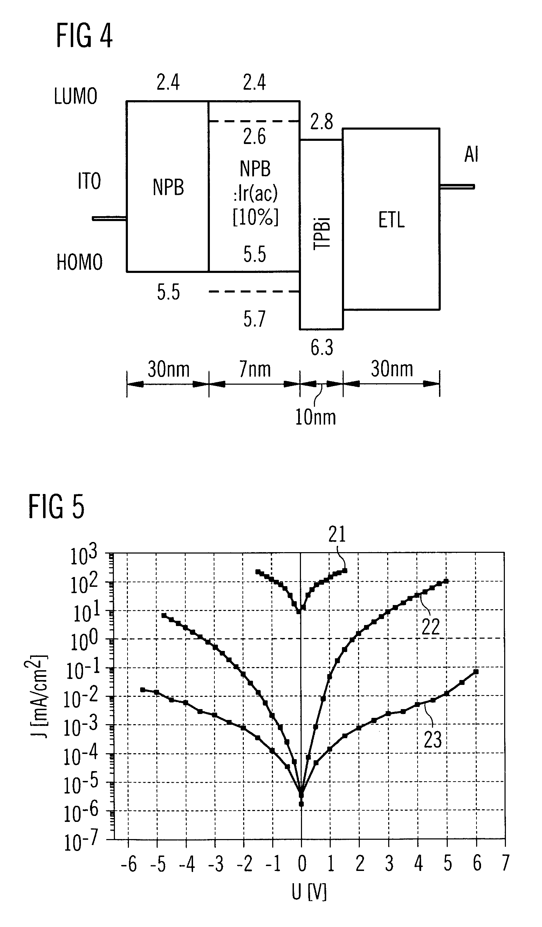

Die Figur 4 zeigt schematisch die Energieniveaus der einzelnen Schichten einer Ausführungsform einer erfindungsgemäßen Vorrichtung, welche als OLED ausgebildet ist. Es sind jeweils die LUMOs und HOMOs der einzelnen Schichten angegeben, so wie die Schichtdicken der einzelnen Schichten. Auf die transparente Anode, welche aus ITO gefertigt ist folgt eine 30 nm dicke Schicht aus NPB. Auf diese erste Schicht aus NPB, welche die Funktion des Löchertransportes übernimmt, folgt eine weitere Schicht in der NPB als Matrixmaterial dient. Diese zweite Schicht aus NPB ist 7 nm dick weist zusätzlich einem Anteil von 10 mol-% Iridium(III)bis(2-methyldibenzo-[f,h]quinoxalin)(acetylacetonat) (Ir(ac)) auf, dessen Strukturformel in Figur 3 dargestellt ist. Sowohl das LUMO wie auch das HOMO der phosphoreszierenden Substanz Ir(ac) liegen knapp unter den entsprechenden Energieniveaus des Matrixmaterials NPD. Auf die emittierende Schicht folgt eine 10 nm dicke Schicht aus TPBI, der organischen Verbindung III. Diese Schicht hat eine löcherblockende Funktion. Die Energieniveaus von TPBI liegen jeweils unter den entsprechenden Energieniveaus der phosphoreszierenden Substanz. Auf die löcherblockierende Schicht folgt die elektronenleitende Schicht (ETL). Diese weist eine Schichtdicke von 30 nm in dieser Ausführungsform auf. Die elektronenleitende Schicht umfasst bei den erfindungsgemäßen Ausführungsformen einen Metallkomplex und eine organische Verbindung. Diese elektronenleitende Schicht ist erhältlich durch gemeinsames Verdampfen des Metallkomplexes mit der organischen Verbindung. Die elektronenleitende Schicht übernimmt in dieser Ausführungsform die Funktion sowohl der elektroneninjizierenden Schicht wie auch der elektronen-transportierenden Schicht. Die Energieniveaus der elektronenleitenden Schicht liegen über den entsprechenden Energieniveaus der löcherblockierenden Schicht. Auf die elektronenleitende Schicht folgt eine Kathode aus Al. Werden nun Spannung an die Anode und die Kathode angelegt so werden von der Anode Löcher und von der Kathode Elektronen in die löchertransportierende beziehungsweise elektronentransportierende Schicht induziert. Von dort aus wandern die positiven Ladungsträger, die "Löcher" und die Elektronen in die NPB-Schicht, welche mit dem phosphoreszierenden Stoff dotiert ist. Bei Rekombination der Löcher und der Elektronen auf dem roten Emitter werden Excitonen gebildet, welche den phosphoreszierenden Stoff zur Emission anregen können.

In den folgenden Figuren 5 bis 8 sind Messkurven sowohl erfindungsgemäßer Ausführungsformen mit Metallkomplex in der ETL, wie auch nicht erfindungsgemäßer Varianten ohne Metallkomplex in der ETL dargestellt. Hierbei wird jeweils die ETL variiert.

Figur 5 zeigt drei Messkurven (21, 22, 23) bei denen die Stromdichte J gegen die Spannung U aufgetragen ist. Für diese Messkurve wurden drei OLED-Bauelemente gefertigt aus jeweils einer 120 nm dicken Indiumzinnoxidelektrode gefolgt von einer 150 nm dicken elektronenleitenden Schicht auf der eine 150 nm dicken Al-Elektrode angeordnet ist. Bei dieser Messung wurde für alle drei Messungen für die elektronenleitenden Schichten 3 der drei Bauelemente die gleiche organische Verbindung, nämlich die organische Verbindung der Struktur V, verwendet. Bei der Messkurve 21 liegt in der organischen Verbindung V ein Anteil von 10 mol-% an W₂(TBD-A)₄ als Metallkomplex vor. In der Messkurve 22 liegt der Anteil an W₂(TBD-A)₄ als Metallkomplex bei nur noch 1 mol-%. Die Messkurve 23 wurde mit der reinen organischen Verbindung V durchgeführt, also ohne Metallkomplex. Die in Figur 5 dargestellte Grafik zeigt, dass bereits mit einem Anteil von 1 mol-% (Messkurve 22) am Metallkomplex bei höheren Spannungen sehr gute Stromdichten erreicht werden können. Auch bei geringer Spannung sind die Stromdichten, welche bereits mit 1 mol-% des Metallkomplex erzielt werden (Messkurve 22) bereits deutlich besser als die Stromdichten, welche mit der reinen organischen Verbindung erzielt werden (Messkurve 23). Die Stromdichten, welche in der Messkurve 21 mit dem 10 mol-%igen Gehalt an W₂(TBD-A)₄ erzielt werden, liegen über dem gesamten Messbereich deutlich über den entsprechenden Werten bei gleicher Spannung der anderen beiden Messkurven 22 und 23. Figur 5 zeigt hiermit deutlich den Einfluss des Metallkomplexes auf die Stromdichte. Die vom dem Metallkomplex zusätzlich bereitgestellten "freien" Elektronen können somit einen entscheidenden Beitrag zum Elektronentransport im OLED-Bauelement leisten.

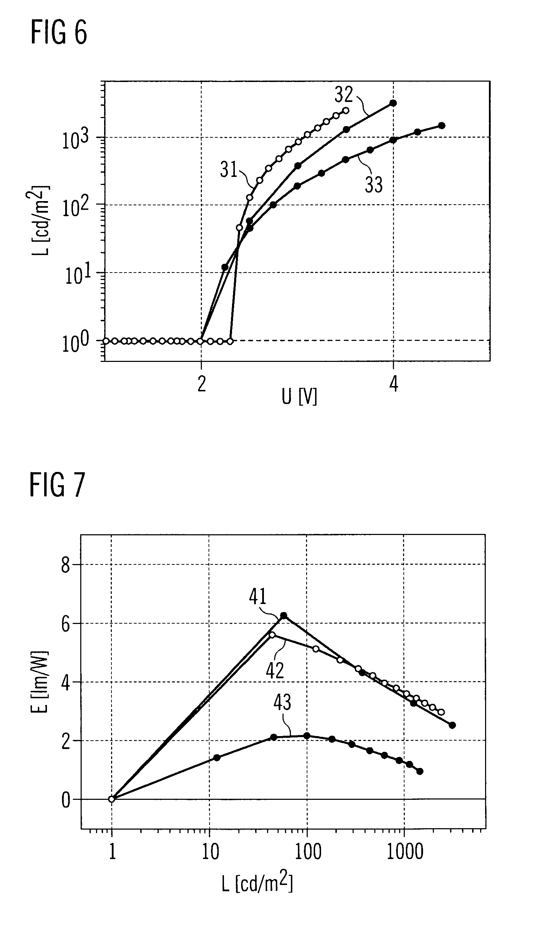

Figur 6 zeigt drei Messkurven (31, 32, 33) bei denen die Lumineszenz L gegen die Spannung U aufgetragen ist. Für die drei Messkurven wurden drei Bauelemente gefertigt, deren Aufbau dem Aufbau entspricht, wie er in den Ausführungen zu Figur 4 beschreiben ist. Für die drei unterschiedlichen Messkurven wurde jeweils das Material für die elektronenleitende Schicht variiert. Für die Messkurve 31 wurde eine elektronenleitende Schicht aus der organischen Verbindung II mit einem Anteil von 10 mol-% an W₂(TBD-A)₄ verwendet. Für die Messkurve 32 wurde eine elektronenleitende Schicht aus der organischen Verbindung I mit einem Anteil von 10 mol-% an W₂(TBD-A)₄ verwendet. Für die Messkurve 33 wurde ein Bauelement mit einer elektronenleitenden Schicht aus der organischen Verbindung I und mit einer zusätzlichen Schicht zwischen der elektronenleitenden Schicht und der Al-Elektrode von einer Dicke von 0,7 nm aus LiF verwendet. In der Messkurve 33 liegt somit in der elektronenleitenden Schicht kein Metallkomplex vor. Aus Figur 6 ist deutlich ersichtlich, dass in den Messkurven 31 und 32 also die Messkurven in den der Metallkomplex jeweils mit 10 mol-% in der elektronenleitenden Schicht vorhanden ist, bessere Lumineszenzen erreicht werden als mit der elektronenleitenden Schicht die nur aus der reinen organischen Verbindung besteht. In dieser Versuchsanordnung wurden mit der organischen Verbindung II noch bessere Werte erzielt, als mit der organischen Verbindung I. Aus Figur 6 ist klar ersichtlich, dass der Metallkomplex eine positive Auswirkung auf die Lumineszenz hat, was aus dem direkten Vergleich der Messkurven 32 und 33 hervorgeht.

Figur 7 zeigt drei Messkurven (41, 42, 43) bei denen die Strahlungseffizienz E gegen die Lumineszenz L aufgetragen ist. Der Aufbau der Bauelemente, die für diese Messkurven verwendet wurden, entspricht dem Aufbau wie er in den Ausführungen zu Figur 4 beschreiben ist. Die Materialien der elektronenleitenden Schicht wurden von Messkurve zu Messkurve variiert. In der Messkurve 41 wurde ein Bauelement mit einer elektronenleitenden Schicht aus der organischen Verbindung I mit einem Anteil von 10 mol% an W₂(TBD-A)₄ verwendet. Für die Messkurve 42 wurde ein Bauelement mit einer elektronenleitenden Schicht aus der organischen Verbindung II mit einem Anteil von 10 mol% an W₂(TBD-A)₄ verwendet. Die Messkurve 43 zeigt die Ergebnisse der Messung eines Bauelements unter Verwendung der organischen Verbindung I, jedoch ohne einen Metallkomplex. Das Bauelement der Messkurve 43 umfasst zwischen der elektronenleitenden Schicht und der Al-Elektrode zusätzlich eine Schicht aus LiF von einer Dicke von 0,7 nm. Wie aus Figur 7 deutlich zu erkennen ist, weisen die Messkurven 41 und 42 bei den die elektronenleitende Schicht neben der organischen Verbindung jeweils zusätzlich einen Gehalt von 10 mol% an dem Metallkomplex aufweisen, eine deutlich verbesserte Effizienz gegenüber der Messkurve 43 mit der elektronenleitenden Schicht auf, die keinen Metallkomplex umfasst. Aus den Messwerten in Figur 7 ist somit deutlich zu erkennen, dass die Effizienz des Bauelements durch den Metallkomplex, welcher zusammen mit der organischen Verbindung verdampft wurde, deutlich gesteigert werden kann.

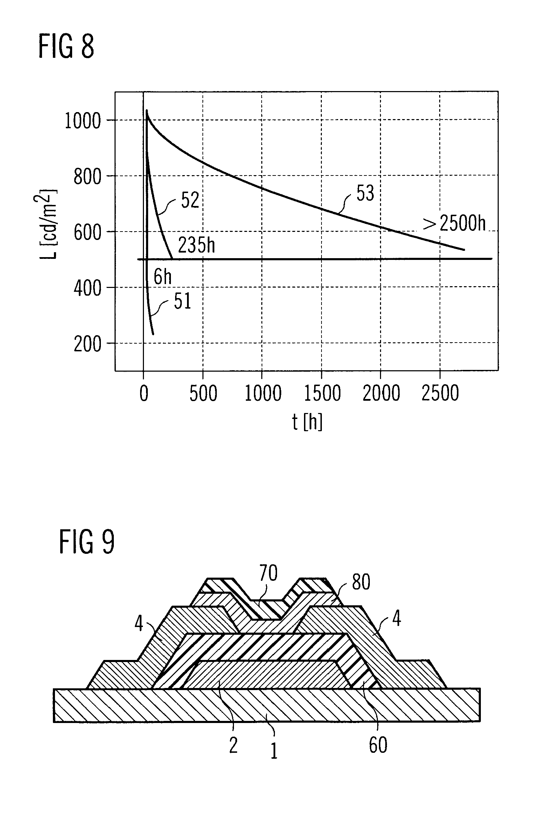

Figur 8 zeigt drei Messkurven (51, 52, 53) bei dem die Lumineszenz L gegen die Zeit t aufgetragen ist. Die "Lebenszeit" ist definiert als 50%-Wert der ursprünglich eingestellten Helligkeit, in diesem Fall 1000 cd/m². Unterschreitet ein Bauelement denn Schwellenwert von 500 cd/m² so gilt es als nicht mehr einsetzbar, seine "Lebenszeit" wird als abgelaufen angesehen. Für die Messkurven wurden jeweils Bauelemente verwendet, deren Aufbau dem Aufbau entspricht, wie er in der Figurenbeschreibung zu Figur 4 beschreiben ist. Für die drei Messkurven wurde jeweils die elektronenleitende Schicht variiert. In der Messkurve 51 wurde ein Bauelement verwendet, bei dem die elektronenleitende Schicht nur aus der organischen Verbindung I besteht. Das Bauelement weist zusätzlich zwischen der elektronenleitenden Schicht und der Al-Elektrode eine weitere Schicht von einer Dicke von 0,7 nm LiF auf. In der Messkurve 52 wurde eine elektronenleitende Schicht aus der organischen Verbindung I mit einem Anteil von 10 mol-% an W₂(TBD-A)₄ verwendet. Für die Messkurve 52 wurde ein Bauelement mit einer elektronenleitenden Schicht aus der organischen Verbindung II mit einem Anteil von 10 mol-% an W₂(TBD-A)₄ verwendet. Figur 8 zeigt deutlich, dass in den beiden Messkurven 52 und 53, bei denen die elektronenleitende Schicht einen Metallkomplex aufweist, deutlich bessere Lebenszeiten erzielt wurden, als in der Messkurve 51, bei der die elektronenleitende Schicht keinen Metallkomplex aufweist. Bei dieser Messung konnte in der Messkurve 53 mit der organischen Verbindung II nochmals deutlich bessere Lebensdauern (> 2500 h) erzielt werden, als in der Messkurve 52 mit der organischen Verbindung I (235 h).

Die in den Figuren 5 bis 8 dargestellten Messkurven zeigen jeweils deutlich, dass die Anwesenheit des Metallkomplexes, welcher gemeinsam mit der organischen Verbindung zur Ausbildung einer elektronenleitenden Schicht verdampft wurde, positiven Einfluss auf die jeweils gemessenen elektrischen und optoelektronischen Parameter hat. Es konnte in den entsprechenden organisch elektronischen Bauelementen eine höhere Stromdichte, höhere Lumineszenz, bessere Effizienz sowie eine längere Lebensdauer durch das gemeinsame Verdampfen des Metallkomplexes mit der organischen Verbindung erzielt werden.

Die Figur 9 zeigt eine schematische Seitenansicht einer Ausführungsform einer erfindungsgemäßen Vorrichtung, welche als organischer Feldeffekttransistor (OFET) ausgebildet ist. Auf dem Substrat 1 ist die erste Elektrode 2 angeordnet, welche als Gate-Elektrodenschicht ausgeformt ist. Auf die erste Elektrode 2 folgt eine Isolatorschicht 60, welche beispielsweise ein Dielektrikum umfassen kann. Die zweite Elektrode 4 ist als Source-Drain-Kontaktschichten ausgeformt und umfasst eine elektronenleitende Schicht. Zwischen Source- und Drain-Kontaktschicht ist ein Halbleiter 80 angeordnet, welcher aus einem lochleitenden Material besteht. Der organische Feldeffekttransistor umfasst des Weiteren eine Deckschicht 70, die beispielsweise zur Verkapselung dienen kann.

## Patentansprüche

1. Organisches elektronisches Bauelement, umfassend
- ein Substrat (1),
- eine erste Elektrode (2),
- eine zweite Elektrode (4),
- eine elektronenleitende Schicht (3), die so angeordnet ist, dass sie mit mindestens einer der Elektroden elektrisch leitend verbunden ist,
wobei die elektronenleitende Schicht (3) einen Metallkomplex umfasst, welcher ein Metallzentralatom und eine organische Verbindung umfasst,
**dadurch gekennzeichnet, dass**
die organische Verbindung ausgewählt ist aus:

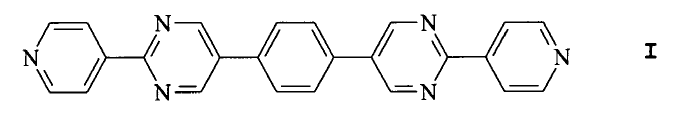

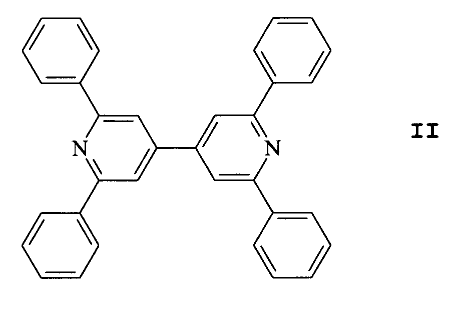

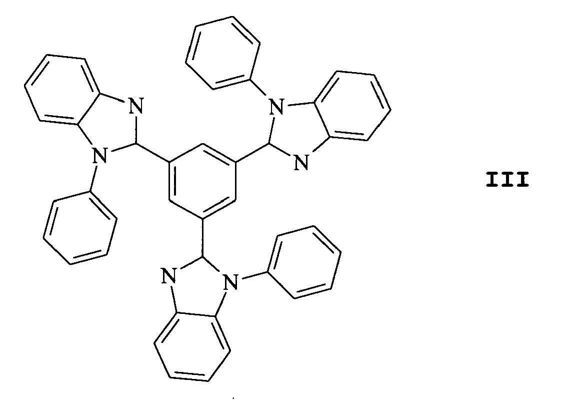

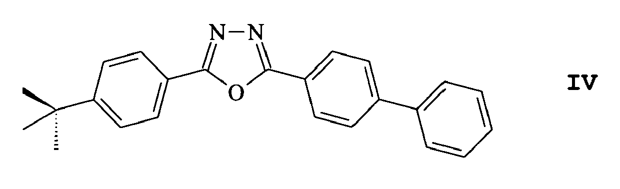

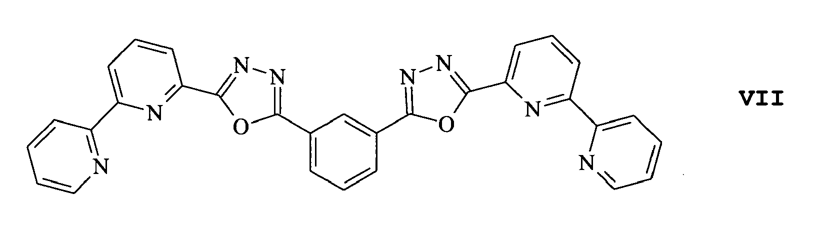

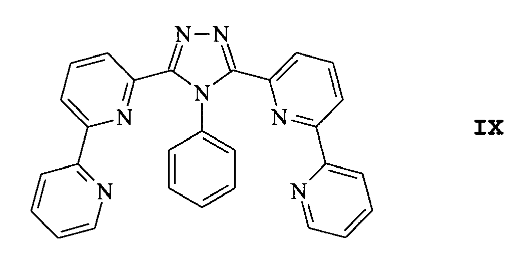

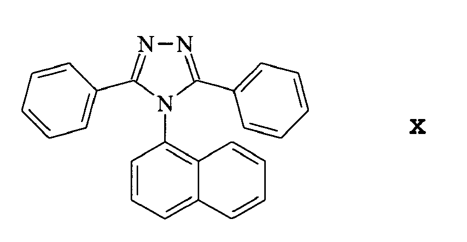

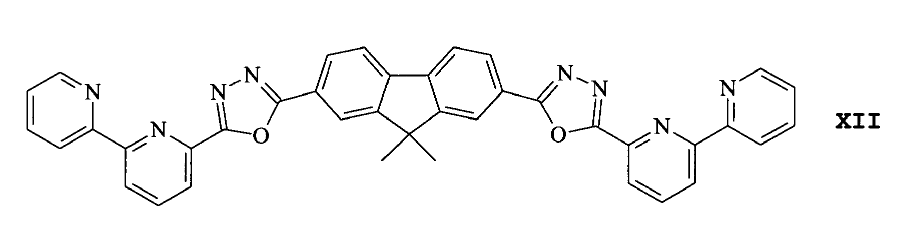

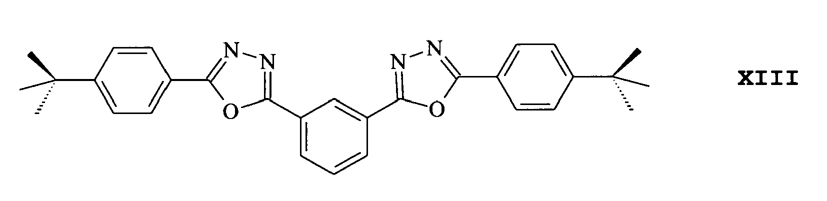

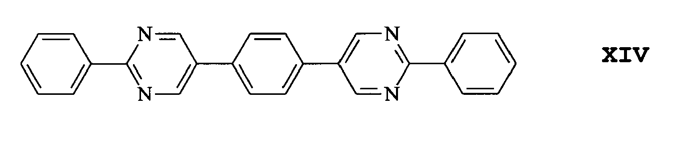

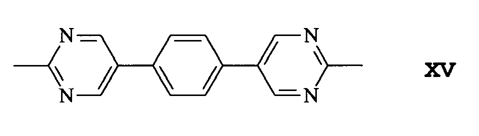

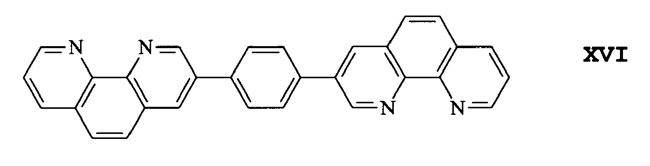

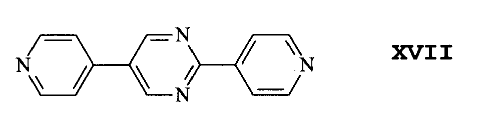

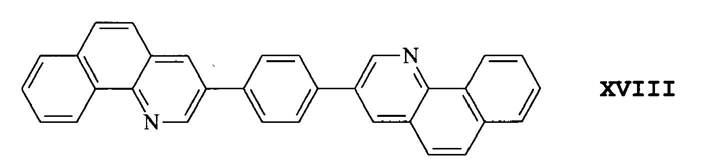

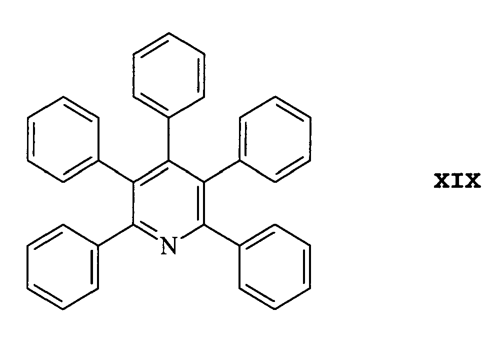

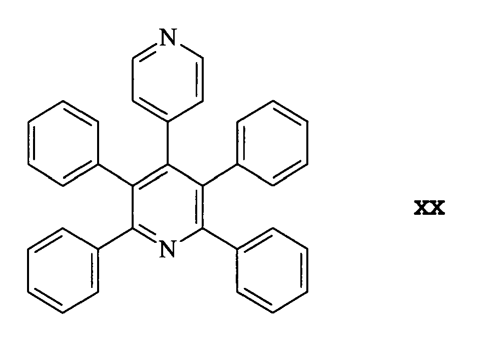

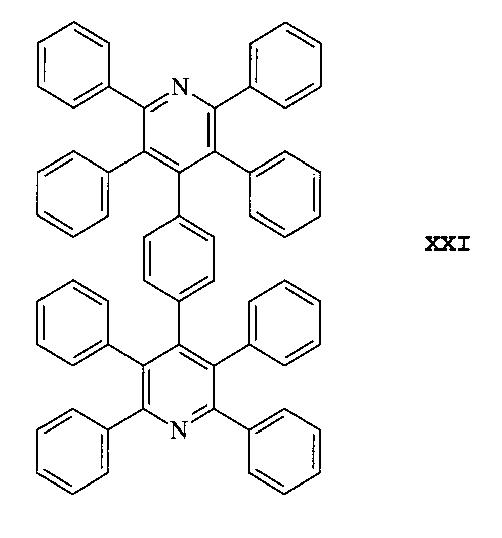

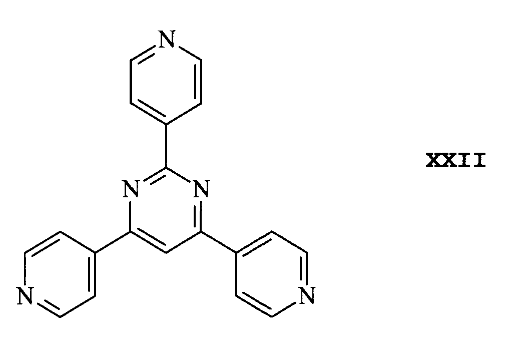

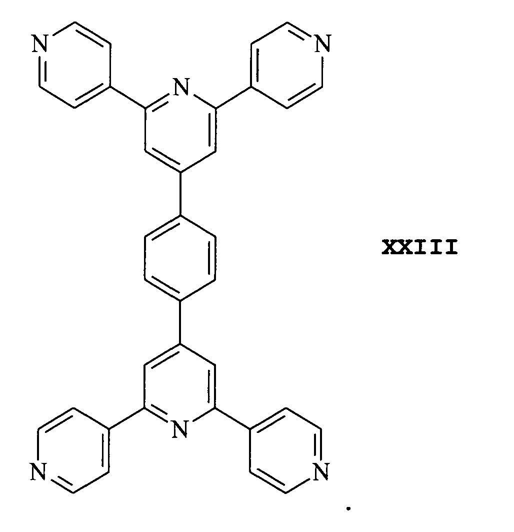

2. Organisches elektronisches Bauelement nach Anspruch 1, wobei der Metallkomplex mehr als ein Metallzentralatom umfasst.

3. Organisches elektronisches Bauelement nach einem der vorhergehenden Ansprüche,
wobei das Metallzentralatom oder die Metallzentralatome ausgewählt sind aus Cr, Mo oder W.

4. Organisches elektronisches Bauelement nach einem der vorhergehenden Ansprüche,
wobei zumindest Teile der organischen Verbindungen zwei Metallkomplexe miteinander verbrücken, so dass eine kettenartige Struktur der Metallkomplexe ausgebildet wird und/oder zumindest Teile der organischen Verbindungen mehr als zwei Metallkomplexe miteinander verbrücken, so dass eine netzartige Struktur der Metallkomplexe ausgebildet wird.

5. Organisches elektronisches Bauelement nach einem der vorhergehenden Ansprüche,
ausgebildet als organische LED (OLED), welche zusätzlich eine organische emittierende Schicht (5) umfasst.

6. Verfahren zur Herstellung eines organischen elektronischen Bauelements, umfassend die Verfahrensschritte:
A) Bereitstellen eines Substrates (1),
B) Aufbringen einer ersten Elektrode (2),
C) Abscheiden einer elektronenleitenden Schicht (3) auf dem Substrat (1),
D) Aufbringen einer zweiten Elektrode (4),
**dadurch gekennzeichnet, dass**
das Abscheiden der elektronenleitenden Schicht (3) durch gleichzeitiges Verdampfen eines Metallkomplexes und einer organischen Verbindung erfolgt, und
beim gleichzeitigen Verdampfen die organische Verbindung in der Gasphase an den Metallkomplex koordiniert,
wobei die organische Verbindung ausgewählt ist aus:

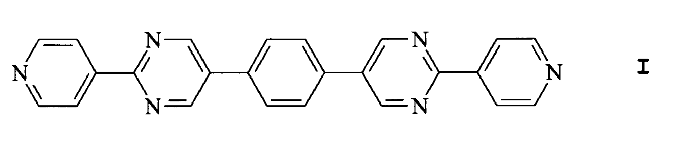

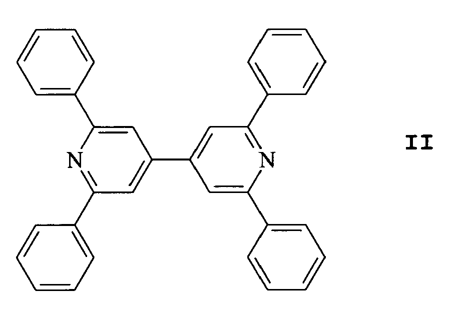

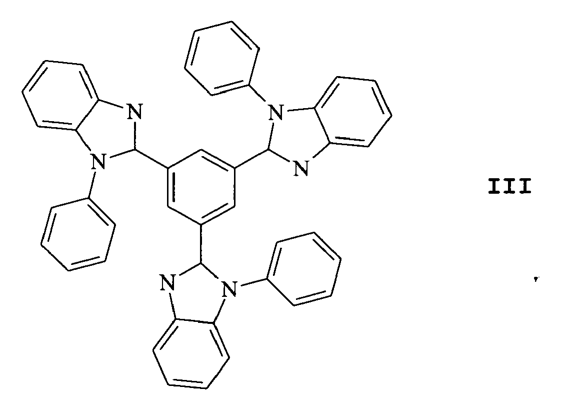

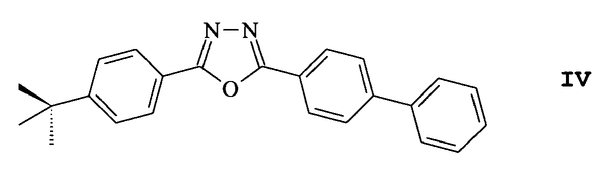

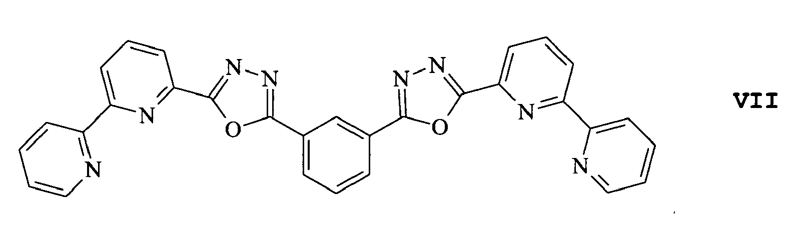

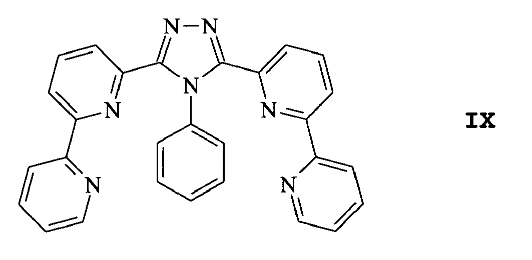

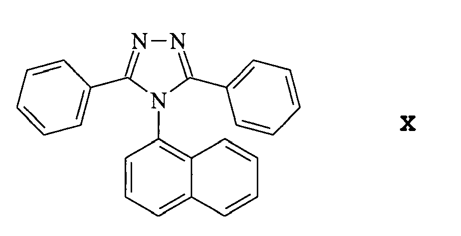

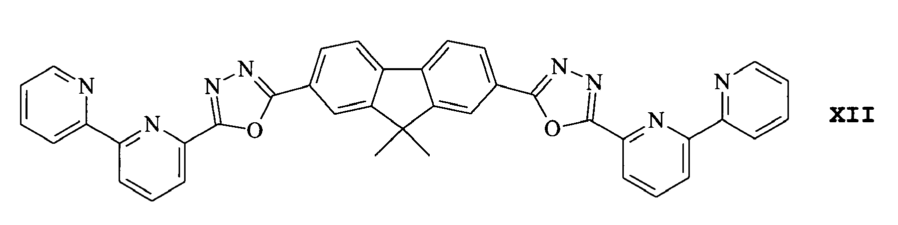

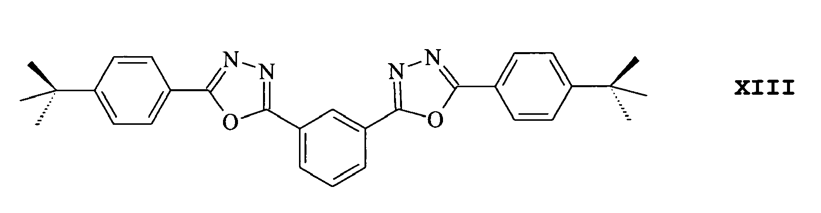

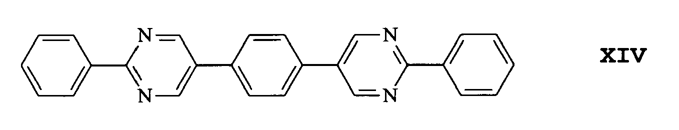

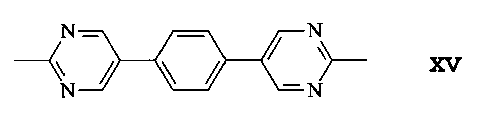

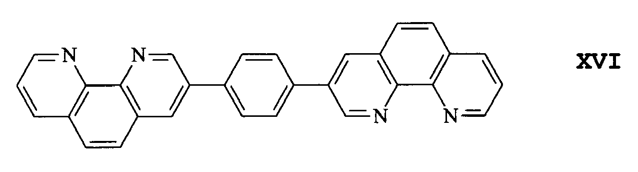

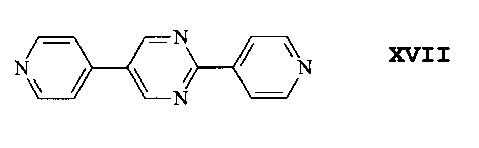

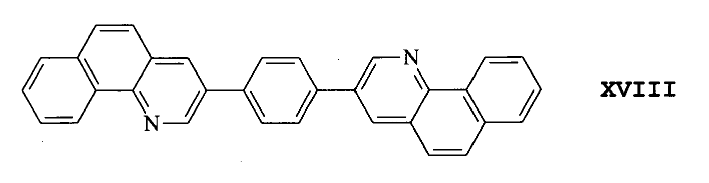

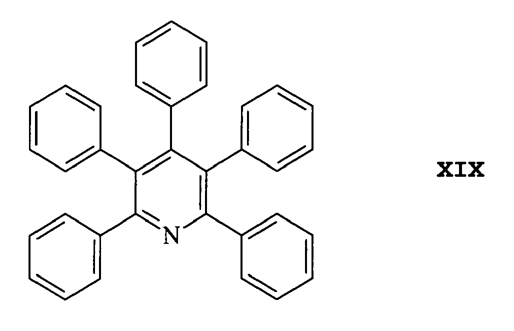

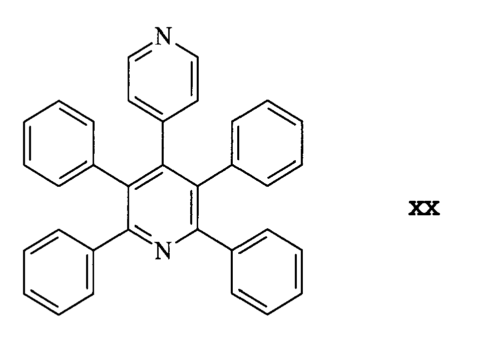

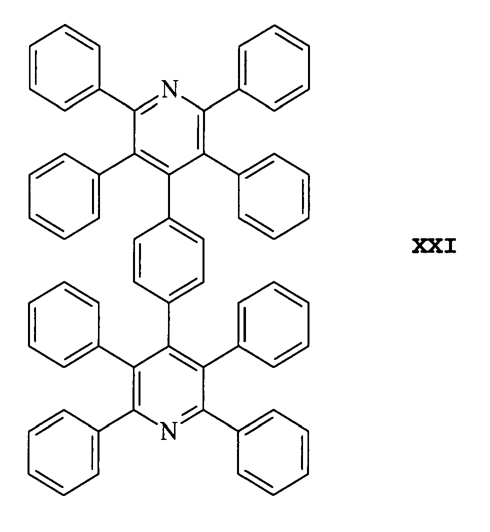

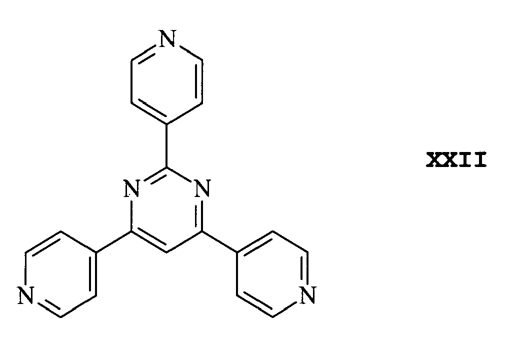

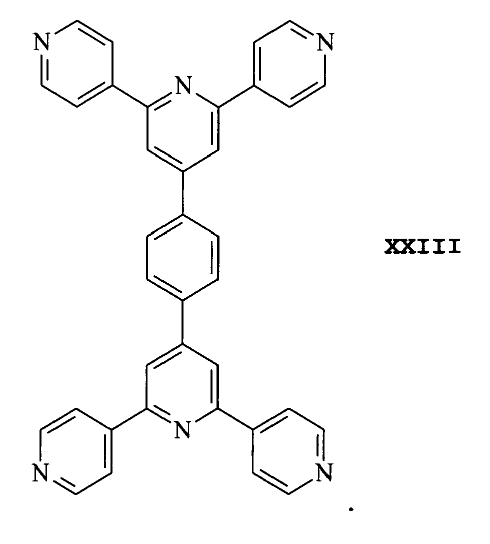

7. Verfahren nach Anspruch 6,
wobei die elektronenleitende Schicht (3) als kettenartige oder netzartige Struktur abgeschieden wird.

8. Verfahren nach Anspruch 7,
wobei der Grad der Vernetzung der elektronenleitenden Schicht (3) durch das Verhältnis zwischen Metallkomplex und organischer Verbindung beim Verdampfen gesteuert wird.

9. Verfahren nach einem der Ansprüche 6 bis 8,
wobei die organische Verbindung vor dem Verdampfen nicht an den Metallkomplex koordiniert.

10. Verfahren nach einem der Ansprüche 6 bis 9,
wobei der Metallkomplex mehr als ein Metallzentralatom umfasst.

11. Verfahren nach Anspruch 10,
wobei das Metallzentralatom oder die Metallzentralatome ausgewählt sind aus Cr, Mo oder W.

12. Verfahren nach einem der Ansprüche 6 bis 11,
wobei die organische Verbindung einen Heteroaromaten umfasst, welcher über eine C-C-Bindung mit einem Aromaten konjugiert ist.

## Claims

1. Organic electronic component comprising
- a substrate (1),
- a first electrode (2),
- a second electrode (4),
- an electron-conducting layer (3) arranged in such a way that it is connected in an electrically conductive manner to at least one of the electrodes, where the electron-conducting layer (3) comprises a metal complex comprising a central metal atom and an organic compound,
**characterized in that**
the organic compound is selected from:

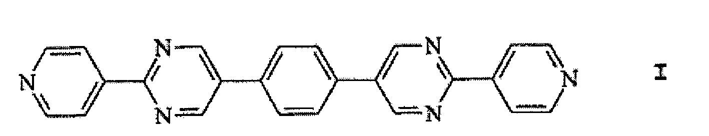

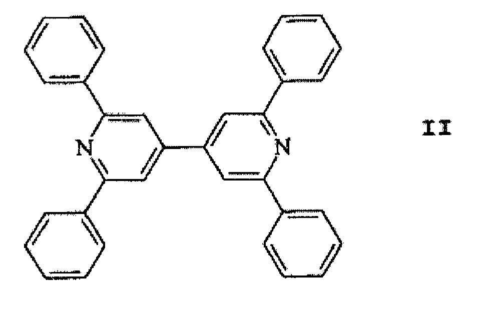

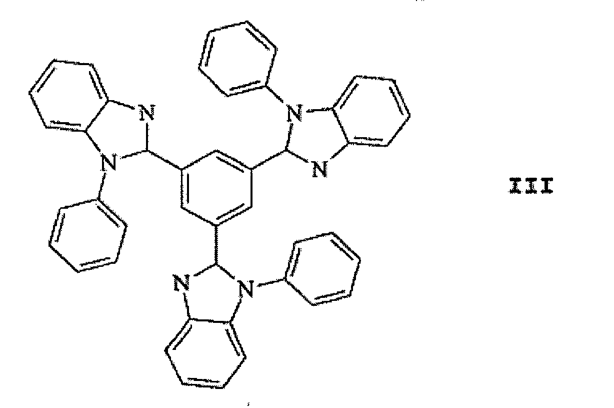

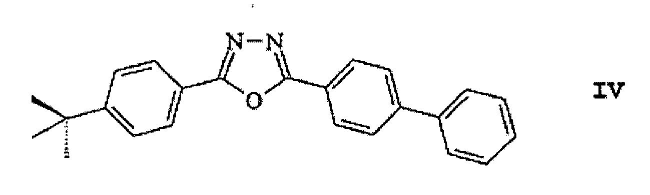

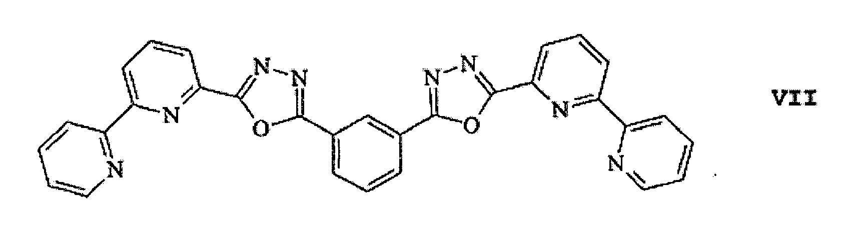

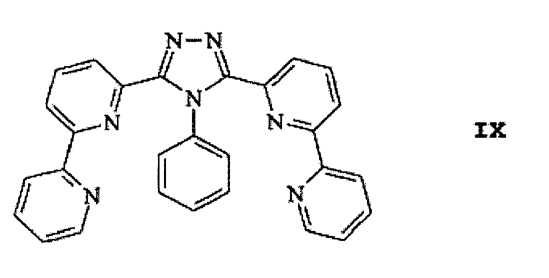

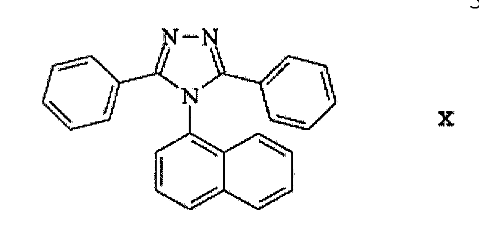

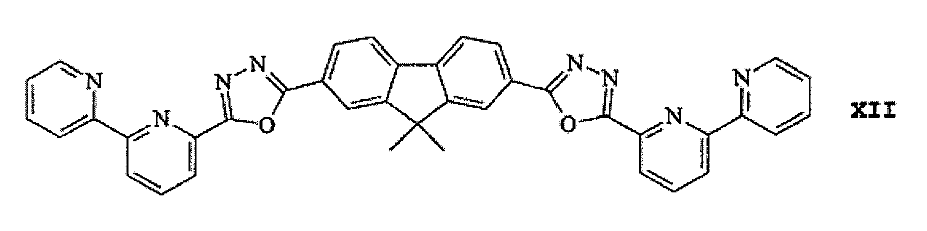

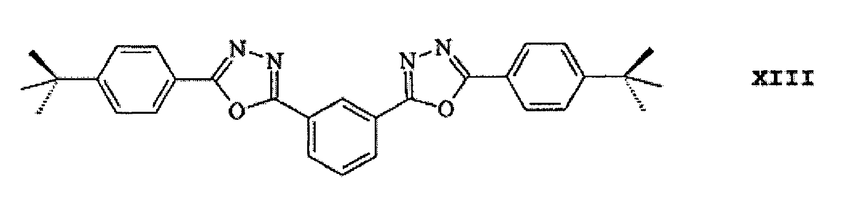

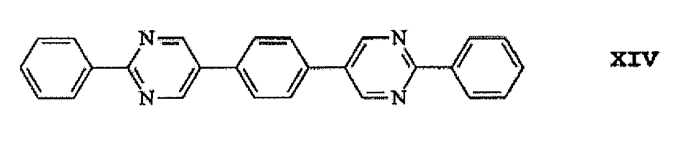

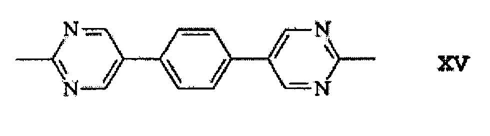

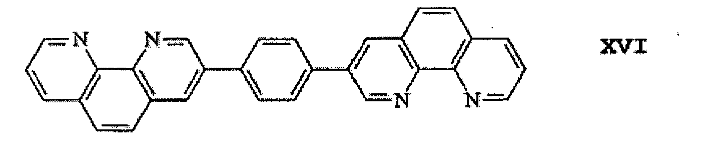

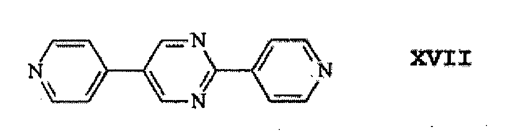

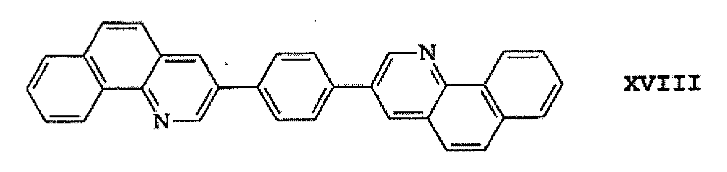

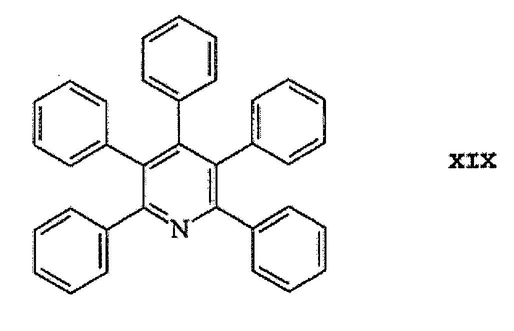

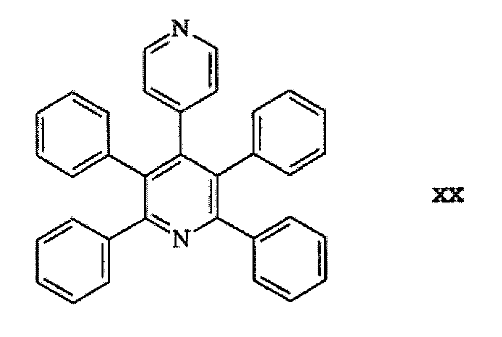

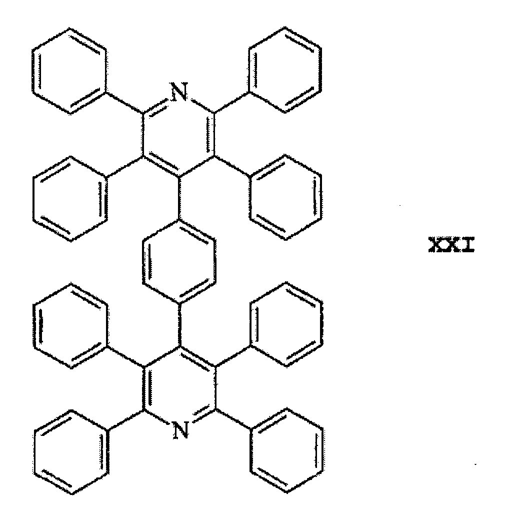

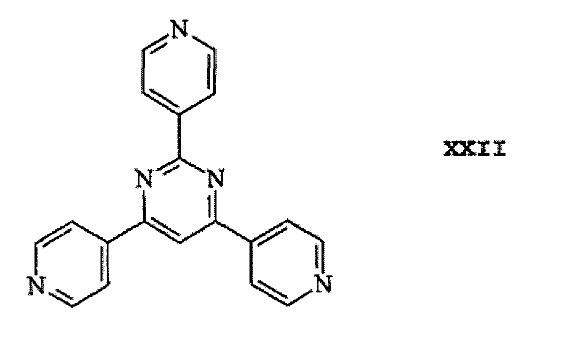

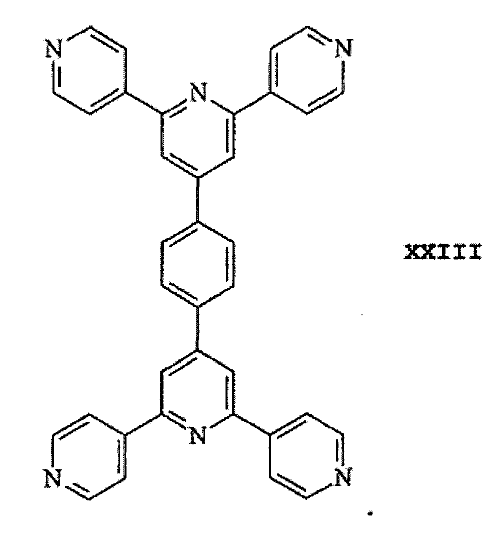

2. Organic electronic component according to Claim 1, wherein the metal complex comprises more than one central metal atom.

3. Organic electronic component according to either of the preceding claims,
wherein the central metal atom(s) is/are selected from Cr, Mo and W.

4. Organic electronic component according to any of the preceding claims,
wherein at least portions of the organic compounds form a bridge between two metal complexes, so as to form a chain-like structure of the metal complexes, and/or at least portions of the organic compounds form bridges between more than two metal complexes, so as to form a network-like structure of the metal complexes.

5. Organic electronic component according to any of the preceding claims,
in the form of an organic LED (OLED), additionally comprising an organic emitting layer (5).

6. Process for producing an organic electronic component, comprising the process steps of:
A) providing a substrate (1),
B) applying a first electrode (2),
C) depositing an electron-conducting layer (3) on the substrate (1),
D) applying a second electrode (4),
**characterized in that**
the depositing of the electron-conducting layer (3) is effected by co-evaporation of a metal complex and an organic compound,
and
in the course of co-evaporation the organic compound in the gas phase coordinates to the metal complex,
wherein the organic compound is selected from:

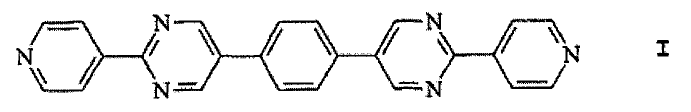

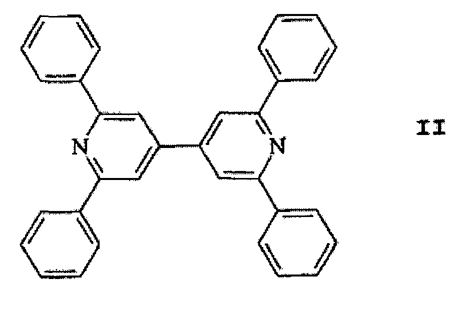

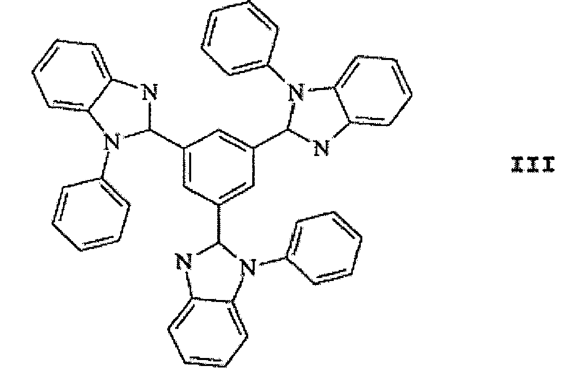

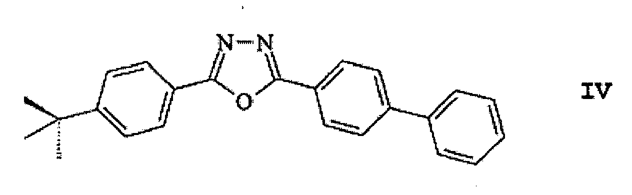

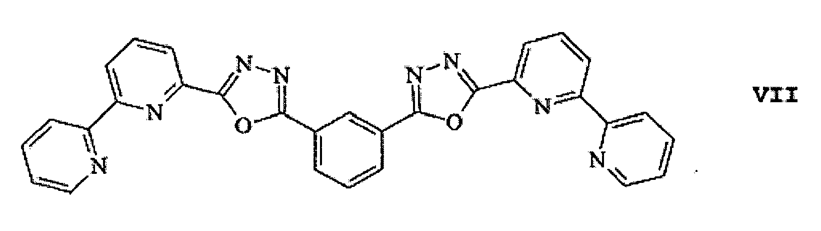

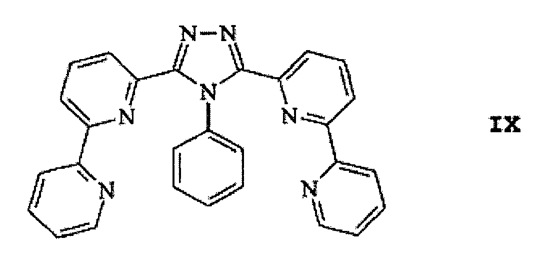

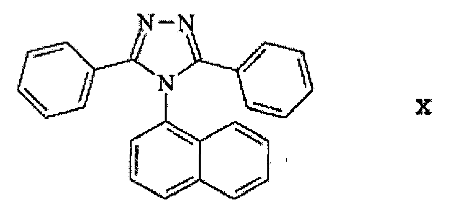

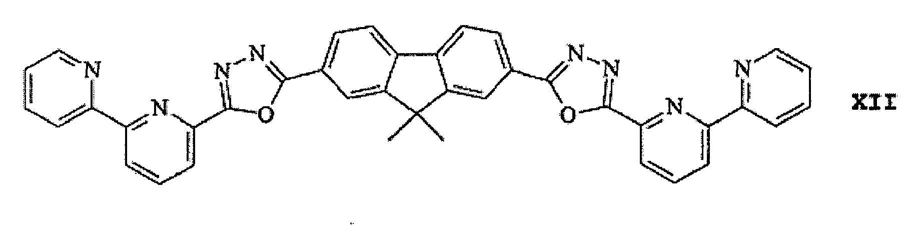

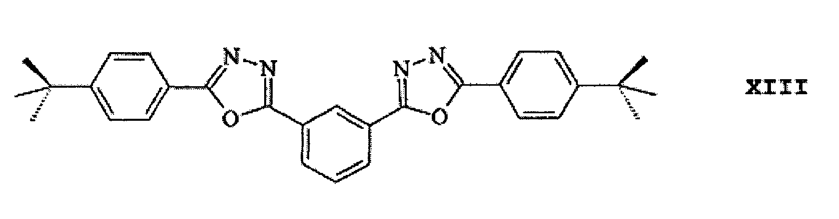

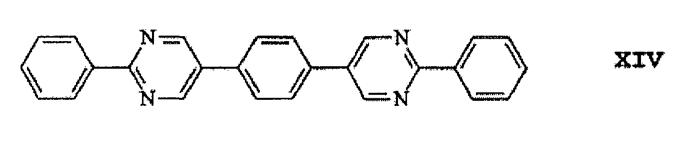

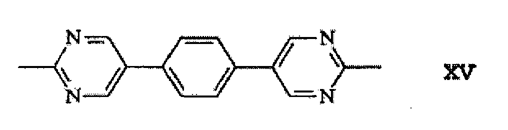

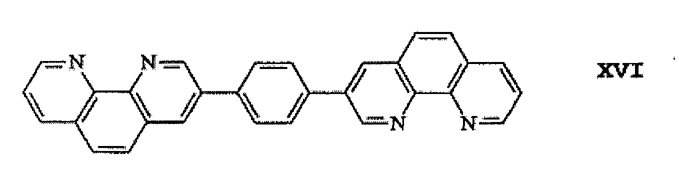

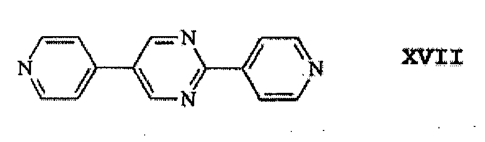

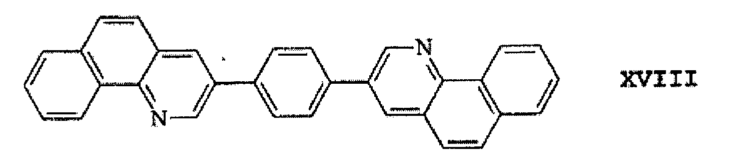

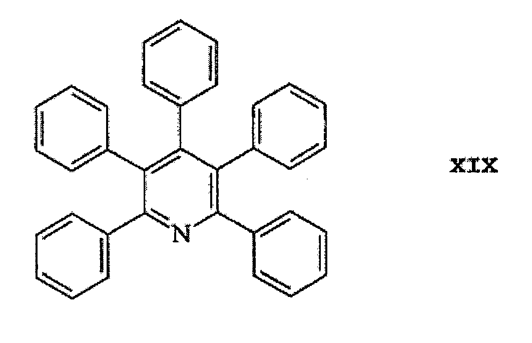

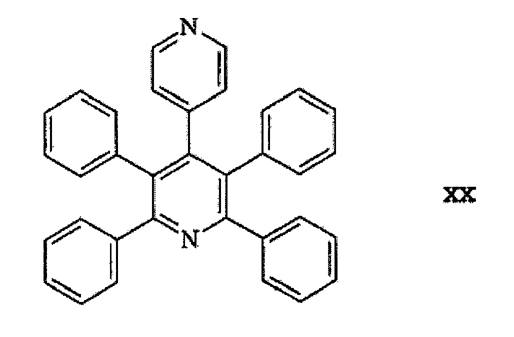

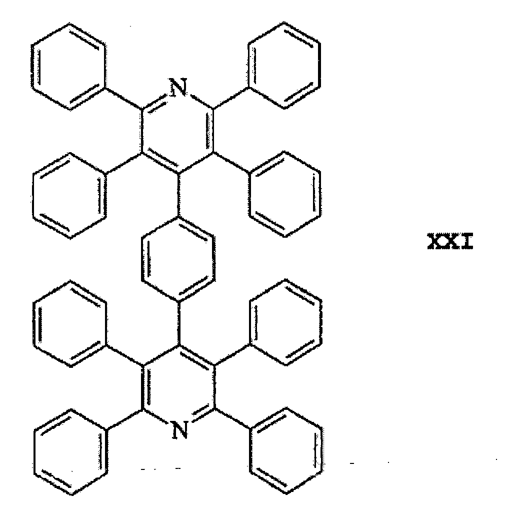

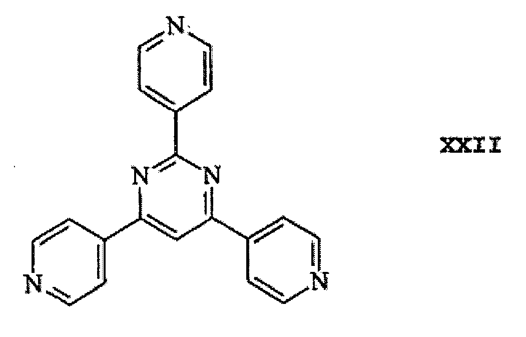

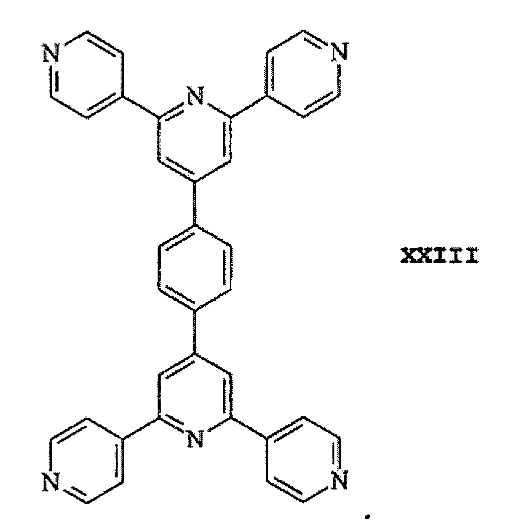

7. Process according to Claim 6,
wherein the electron-conducting layer (3) is deposited as a chain-like or network-like structure.

8. Process according to Claim 7,
wherein the degree of crosslinking of the electron-conducting layer (3) is controlled via the ratio between metal complex and organic compound in the evaporating operation.

9. Process according to any of Claims 6 to 8,
wherein the organic compound is not coordinated to the metal complex prior to the evaporating operation.

10. Process according to any of Claims 6 to 9,
wherein the metal complex comprises more than one central metal atom.

11. Process according to Claim 10,
wherein the central metal atom(s) is/are selected from Cr, Mo and W.

12. Process according to any of Claims 6 to 11,
wherein the organic compound comprises a heteroaromatic compound conjugated to an aromatic compound via a C-C bond.

## Revendications

1. Composant électronique organique, comprenant
- un substrat (1),
- une première électrode (2),
- une deuxième électrode (4),
- une couche conductrice d'électrons (3), qui est disposée de manière telle qu'elle est reliée de manière électriquement conductrice à au moins une des électrodes,
la couche conductrice d'électrons (3) comprenant un complexe métallique, qui comprend un atome central métallique et un composé organique, **caractérisé en ce que** le composé organique est choisi parmi :

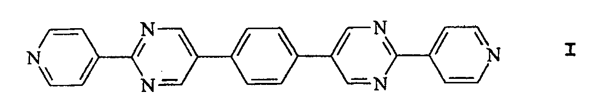

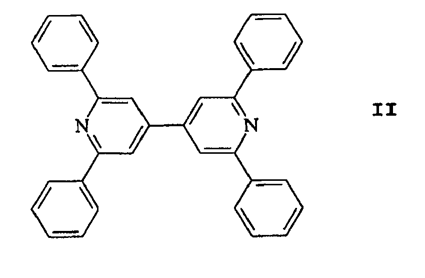

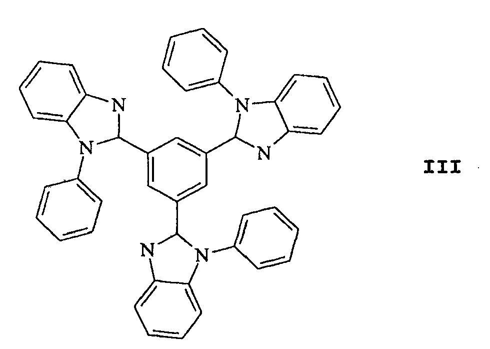

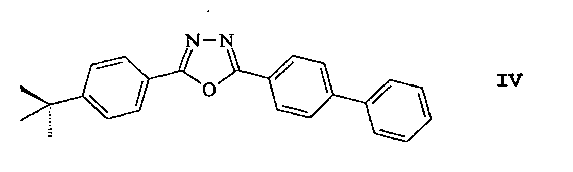

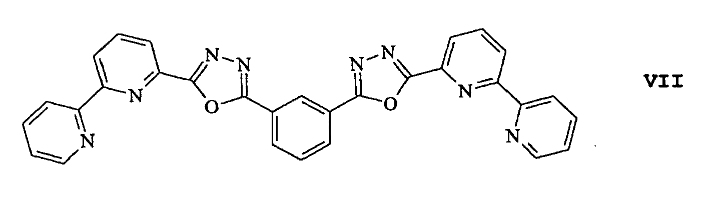

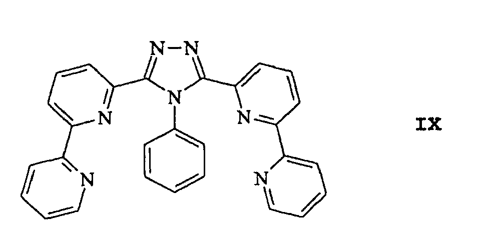

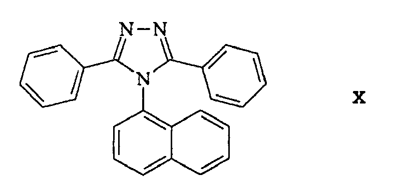

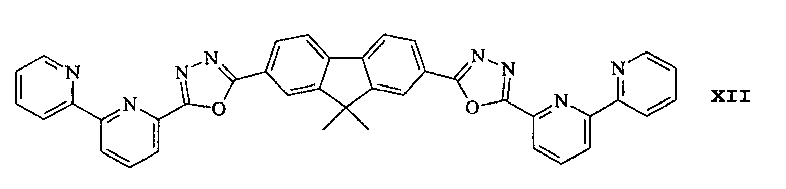

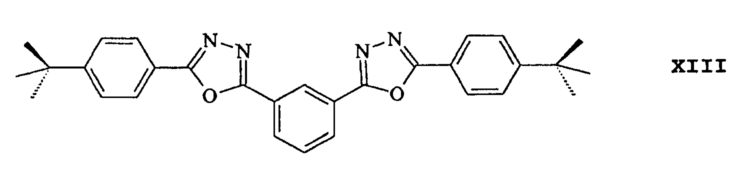

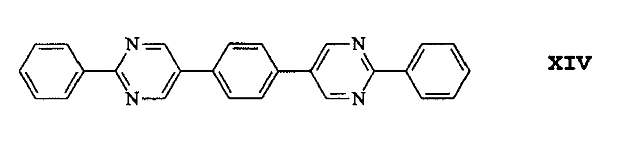

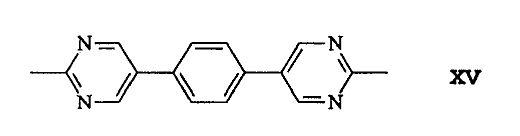

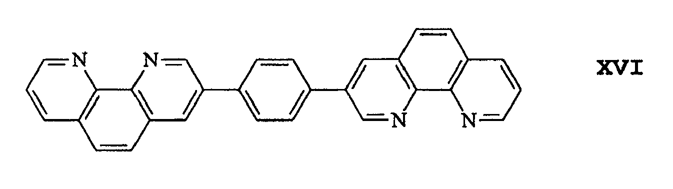

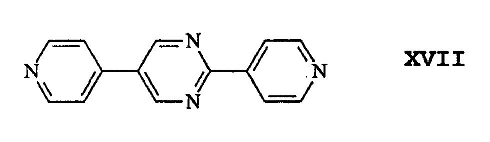

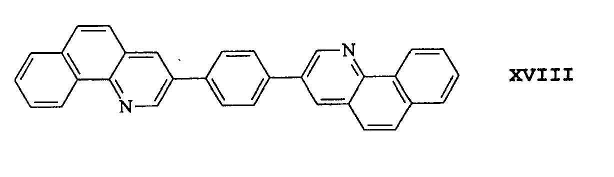

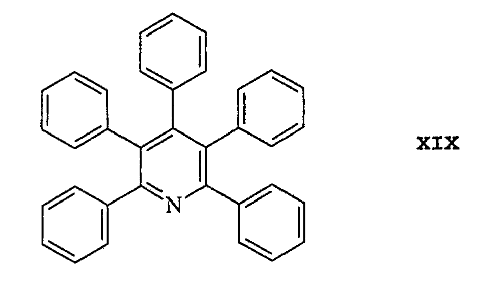

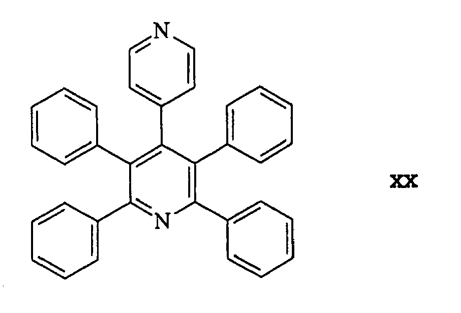

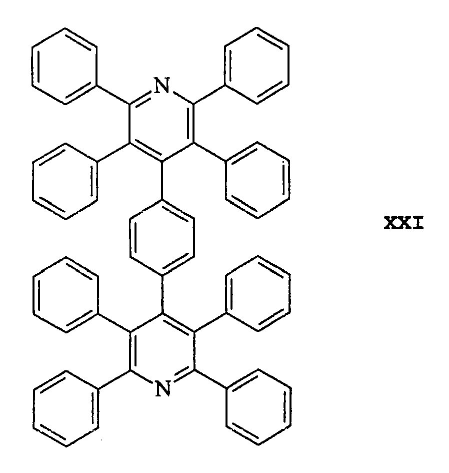

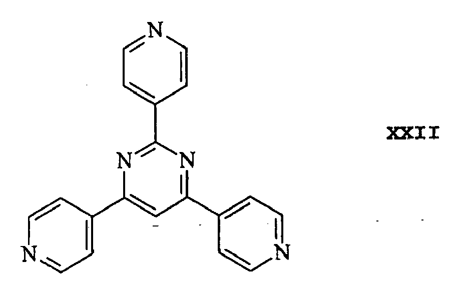

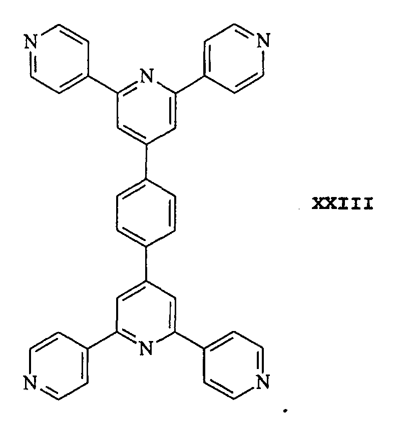

2. Composant électronique organique selon la revendication 1, le complexe métallique comprenant plus d'un atome central métallique.

3. Composant électronique organique selon l'une quelconque des revendications précédentes, l'atome central métallique ou les atomes centraux métalliques étant choisi(s) parmi Cr, Mo ou W.

4. Composant électronique organique selon l'une quelconque des revendications précédentes, deux complexes métalliques étant reliés l'un à l'autre par au moins des parties des composés organiques avec formation d'un pont, de telle sorte qu'une structure de type chaîne des complexes métalliques se forme, et/ou plus de deux complexes métalliques étant reliés l'un à l'autre par au moins des parties des composés organiques avec formation d'un pont, de telle sorte qu'une structure de type réseau des complexes métalliques se forme.

5. Composant électronique organique selon l'une quelconque des revendications précédentes, conçu en tant que DEL organique (DELO), qui comprend en outre une couche émettrice organique (5).

6. Procédé pour la fabrication d'un composant électronique organique, comprenant les étapes de procédé :
A) mise à disposition d'un substrat (1),
B) application d'une première électrode (2),
C) dépôt d'une couche conductrice d'électrons (3) sur le substrat (1),
D) application d'une deuxième électrode (4),
**caractérisé en ce que** le dépôt de la couche conductrice d'électrons (3) a lieu par l'évaporation simultanée d'un complexe métallique et d'un composé organique et le composé organique se coordine dans la phase gazeuse au complexe métallique lors de l'évaporation simultanée, le composé organique étant choisi parmi :

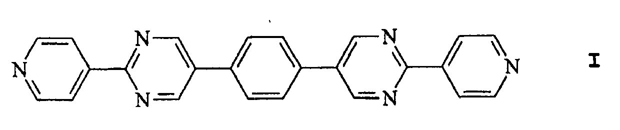

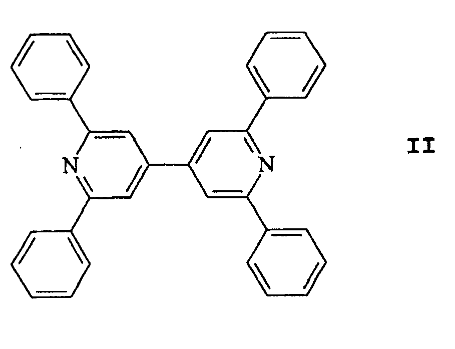

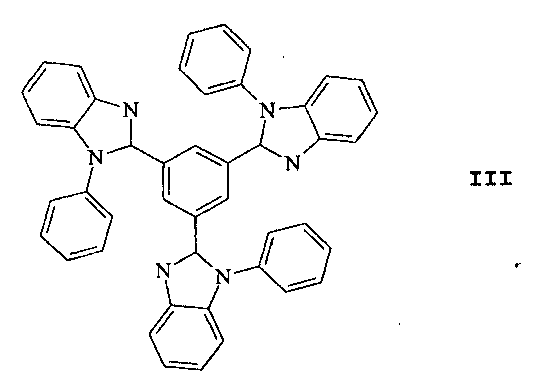

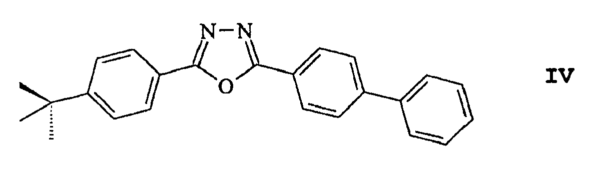

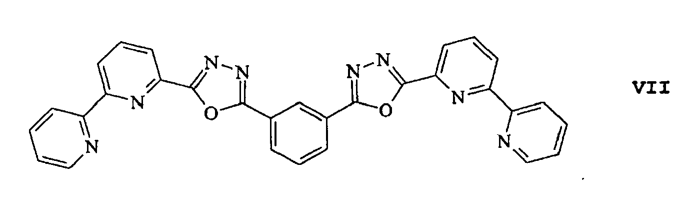

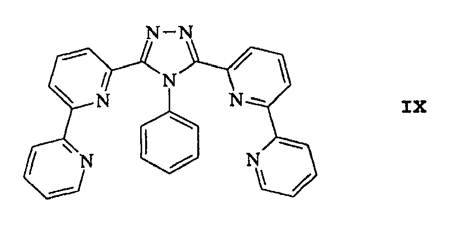

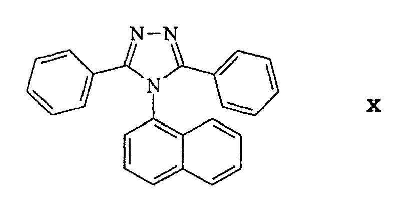

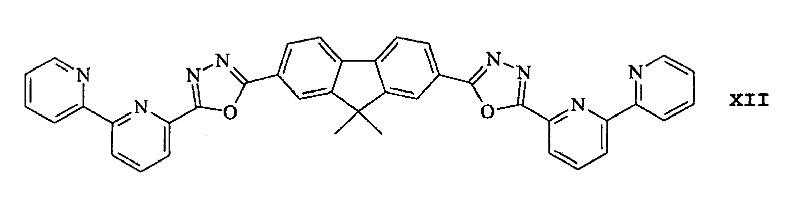

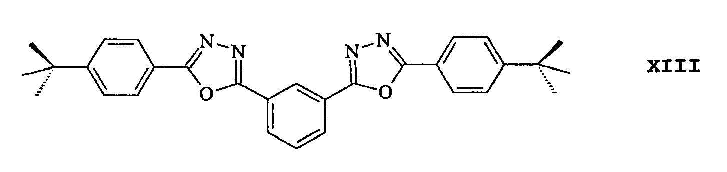

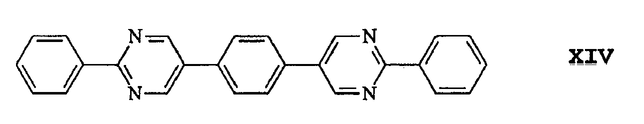

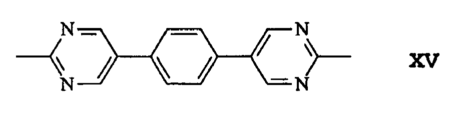

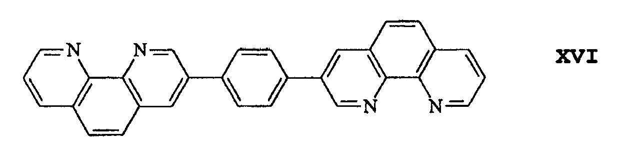

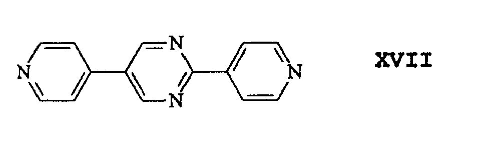

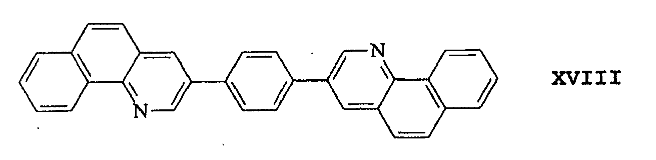

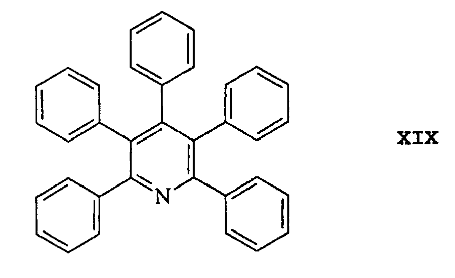

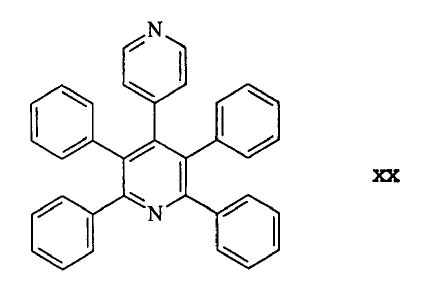

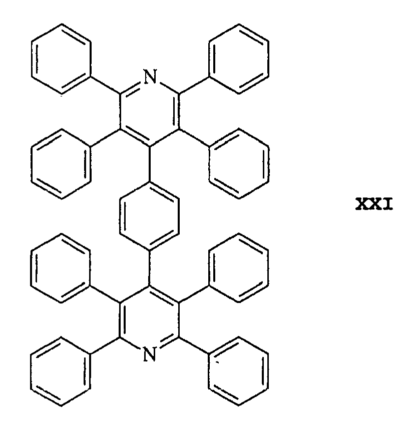

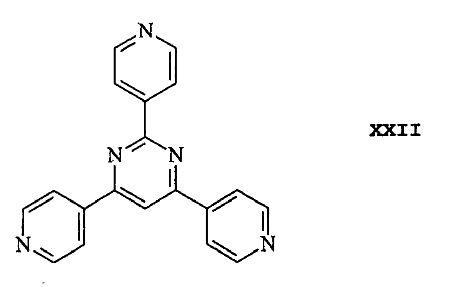

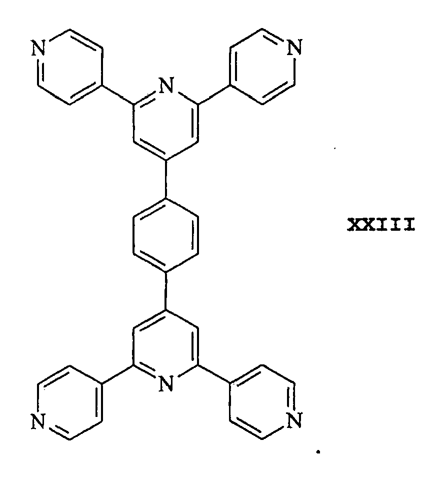

7. Procédé selon la revendication 6, la couche conductrice d'électrons (3) étant déposée sous forme de structure de type chaîne ou de type réseau.

8. Procédé selon la revendication 7, le degré de réticulation de la couche conductrice d'électrons (3) étant régulé par le rapport entre le complexe métallique et le composé organique lors de l'évaporation.

9. Procédé selon l'une quelconque des revendications 6 à 8, le composé organique ne se coordinant pas au complexe métallique avant l'évaporation.

10. Procédé selon l'une quelconque des revendications 6 à 9, le complexe métallique comprenant plus d'un atome central métallique.

11. Procédé selon la revendication 10, l'atome central métallique ou les atomes centraux métalliques étant choisi(s) parmi Cr, Mo ou W.

12. Procédé selon l'une quelconque des revendications 6 à 11, le composé organique comprenant un hétéroaromatique, qui est conjugué à un aromatique via une liaison C-C.
